# EUROPÄISCHE PATENTSCHRIFT

(11) **EP 4 435 442 B1**
(45) Veröffentlichungstag und Bekanntmachung des Hinweises auf die Patenterteilung: **11.06.2025**
(21) Anmeldenummer: 24163197.7
(22) Anmeldetag: 13.03.2024
(51) Int. Cl.: G01R 31/08, G01R 31/52, G01R 31/58

(54) **PRÜFGERÄT UND VERFAHREN ZUR PRÜFUNG EINES HOCH- ODER MITTELSPANNUNGSKABELS**
TESTING DEVICE AND METHOD FOR TESTING A HIGH OR MEDIUM VOLTAGE CABLE
APPAREIL DE CONTRÔLE ET PROCÉDÉ DE CONTRÔLE D'UN CÂBLE HAUTE OU MOYENNE TENSION

(30) Priorität: 20.03.2023 DE 102023106958
(43) Veröffentlichungstag der Anmeldung: 25.09.2024
(73) Patentinhaber: b2 electronics GmbH, 6833 Klaus (AT)
(72) Erfinder: Kruijen, Joseph, 6960 Buch (AT); Mathies, Christian, 6781 Bartholomäberg (AT); Baldauf, Stefan, 6835 Zwischenwasser (AT)
(74) Vertreter: Grättinger Möhring von Poschinger Patentanwälte Partnerschaft mbB

(56) Entgegenhaltungen:
- DE-A1- 102009 037 445
- DE-B3- 102012 024 560
- US-A- 5 352 984
- US-B2- 9 989 581
- HVI HIGH VOLTAGE INC: "Application: VLF Cable Testing & Fault Locating", 1 May 2020 (2020-05-01), XP093192014, Retrieved from the Internet <URL:https://hvinc.com/wp-content/uploads/2020/05/Application-Cable-Testing-Fault-Locating-VLF-Thumper-Combo.pdf>
- B2 ELECTRONICS: "HVA68TD", 1 December 2023 (2023-12-01), XP093192051, Retrieved from the Internet <URL:https://batavia.internal.epo.org/citenpl/prod/web/citenpl/citenpl.html>

## Beschreibung

Die vorliegende Erfindung betrifft ein Prüfgerät zur Prüfung eines Hoch- oder Mittelspannungskabels, insbesondere zur Prüfung von Isolationen in Koaxialkabeln zur Strom-/Energieverteilung in elektrischen Versorgungsnetzen mittels VLF-Prüfverfahren. Ferner betrifft die Erfindung ein Verfahren zur Prüfung, insbesondere zur Diagnose und Ortung, eines Hoch- oder Mittelspannungskabelfehlers.

Die Prüfung von Hoch- oder Mittelspannungskabeln (hierin auch als Prüfling bezeichnet, beispielsweise im Rahmen von lokalen/regionalen Energienetzen im Erdreich verlegte oder durch Wasser verlaufende Kabel) umfasst die Prüfung zum Zweck der Ermittlung von möglicherweise existierenden Defekten oder Vorschädigungen (hierin auch als Fehlstelle eines Hoch- oder Mittelspannungskabels bezeichnet). Fehlstellen können sich beispielsweise an der Isolation eines Hochspannungskabels ausbilden. Eine Fehlstelle kann ein Defekt in der Kabelisolierung sein, der einen Durchbruch erzeugt. Eine Fehlstelle kann ferner ein Defekt in der Kabelisolierung sein, der noch keinen Durchbruch oder einen Durchbruch erzeugt. Dies können sogenannte Water-Trees oder Electrical-Trees sein. Neben der Existenz eines Defekts ist eine Ortung der Lage des Defekts für die Behebung des Fehlers notwendig. Insbesondere bei Kabellängen von einigen Kilometern ist eine möglichst schnelle und präzise Ortung der Lage des Defekts von Vorteil.

Mit Blick auf das Vorliegen einer Vorschädigung ermöglichen mobile VLF-Prüfgeräte eine Prüfung eines Prüflings mithilfe einer Prüfspannung z. B. im Bereich von 20 kVpeak bis 120 kVpeak, (allgemein nicht begrenzt), die mit einem hochpräzisen Spannungsverlauf bei einer Frequenz im Bereich von 0,01 Hz bis 1 Hz, die sogenannte Very Low Frequency (VLF), erzeugt und an den Prüfling als Energiekabel am Leiter gegenüber Schutzerde angelegt wird. VLF-basierte Prüfverfahren sind bekannt und beispielsweise in IEEE 400.2 definiert.

Für die Spannungserzeugung umfassen VLF-Prüfgeräte spezielle VLF-Prüfgeneratoren (auch als VLF-Hochspannungsquellen/VLF-High Voltage-Source/Quellen bezeichnet). Ein VLF-Prüfgenerator kann vorzugsweise zwei Hochspannungsquellen (Transformatoren mit Kaskadenschaltung) und einen Ausgangsverstärker (in Form von Stromquellen) umfassen, die gemeinsame eine sehr störungsarme sinusförmige Ausgangsspannung (die "Prüfspannung") erzeugen. Schaltungsanordnungen für die Erzeugung derartiger Prüfspannungen werden beispielsweise in der DE 10 2012 024 560 B3 der Anmelderin oder der DE 195 13 441 A1 offenbart.

US 5,352,984 offenbart ferner ein System und Verfahren zur Fehler- und Spleißerkennung.Für eine Diagnose hinsichtlich des Vorliegens einer Vorschädigung (z. B. Water-Tree) kann in einer sogenannten Tangens-Delta-Messung ein Verlustfaktor bestimmt werden. Für eine Tangens-Delta-Messung kann - trotz Verbindung des Prüflings an Schutzerde - der Strom durch den Defekt erfasst werden, d. h., ohne dass der Prüfling von der Schutzerde zu trennen ist. Beispielsweise kann ein Stromerfassungs-Element (z.B. Widerstand als Strom-Shunt) für eine Tangens-Delta-Messung intern in einem VLF-Prüfgenerator vorgesehen werden, mit dem der Strom durch den Prüfling erfasst werden kann. Beispielsweise kann das Erfassen des Stromes an einem Sammelpunkt im VLF-Prüfgenerator erfolgen, durch den der Strom vom Prüfling zurück zur Hochspannungs-Kaskade fließt (siehe z. B. DE 10 2012 024 560 B3 bezüglich einer besonders vorteilhaften Anordnung für eine hochgenaue Diagnosemessung). Der Prüfstrom wird z. B. mit einem Widerstand im Bereich von 0,01 kΩ bis 1 kΩ in einem Frequenzbereich bis üblicherweise 5 kHz (nicht mehr als 50 kHz) erfasst und dient zur Bestimmung der Verlustleistung (resistiver Leckstrom) über die Phasenverschiebung.

Im Stand der Technik sind für die Ortung eines Defekts in einem Prüfling verschiedene sogenannte Fehlerortungsmethoden bekannt. Diese Methoden bauen auf der Feststellung auf, dass ein Fehler in einem Energiekabel vorliegt, der beispielsweise anhand eines Spannungsdurchschlags zwischen Leiter und Schirm während des Betriebes oder während einer Prüfung erkannt wurde. Für die Fehlerortung wird erneut mit einem Hochspannungsgenerator am Prüfling eine Spannung im Bereich von z. B. 8 kV bis 40 kV angelegt, bis es wieder zu einem Durchschlag am Hochspannungskabel kommt. Die Geräte sind hinsichtlich der Energiebereitstellung baulich begrenzt. Üblicherweise können Energien z. B. im 1000 kJ-Bereich (Strompuls basierend auf z. B. 10 µF bis 20 µF im kA-Bereich) bereitgestellt werden. Der Strompuls löst eine Schwingung (transiente Welle) im Prüfling aus, deren Verlauf aufgezeichnet wird. Die Schwingung im Prüfling kann z. B. mittels eines kapazitiven Spannungsteilers, der zur Spannungsmessung zusätzlich zum Hochspannungsgenerator am Prüfling extern (d. h. hochspannungsseitig) angeschlossen wird, erfasst werden. Alternativ kann sie mittels einer Induktivität, die zur Messung des zirkulierenden Stroms extern (d. h. hochspannungsseitig) an einer Zuleitung vorgesehen wird, erfasst werden. Die Entfernung zum Fehler ergibt sich aus der Frequenz der Schwingung. Siehe bezüglich beispielhafter Fehlerortungsmethoden beispielsweise IEEE 1234-2019, Kapitel 7.2.9 "Impulse current method (also surge pulse reflection)*"* und Kapitel 7.2.11 "Decay method" sowie CIGRE B1 773 September 2019, Kapitel 2.3.5 "Decay method and differential decay method*"* oder Kapitel 2.3.6.1 "Impluse Current Method*".* All diese Fehlerortungsmethoden basieren auf einer kapazitiven (decay method) oder induktiven (impulse current method) Auskopplung außerhalb des VLF-Prüfgenerators, wie es auch schematisch in der Anordnung der DE 10 2009 037 445 B4 (externe Koppelelemente für Spannung oder Strom sowie separate Einheit zur Durchschlagserkennung) beschrieben wird.

Gemäß der DE 10 2009 037 445 A1 ist bei einer Anordnung zur Prüfung und Fehlerortung vorgesehen, mit einer VLF-Spannung intermittierende bzw. reversible/irreversible Isolationsfehler zu ermitteln und gleichzeitig eine Lokalisierung der auftretenden Fehler zu gewährleisten. Hierzu ist vorgesehen, dass bei einem Isolationsdurchschlag im Prüfkabel über ein Koppelelement eine auftretende Grundwelle und/oder auftretende Spannungs- und Stromwandlerwellen auskoppelbar sind und über eine Einheit zur Signalaufnahme und Signalauswertung eine Fehlerposition ermittelbar ist.

In der Broschüre "Application: VLF Cable Testing & Fault Locating" der Hvi High Voltage Inc. - siehe https://hvinc.com/wp-content/uploads/2020/05/Application-Cable-Testing-Fault-Locating-VLF-Thumper-Combo.pdf - wird ein Ansatz zur umfänglichen Kabelvorsorge mit dem Gerät VT Series model VT33 VLF AC Hipot & Thumper System beschreiben.

US 9,989,581 B2 betrifft Verfahren und Einrichtungen zur Ortung von Teilentladungen in elektrischen Kabeln mit einer an das zu prüfende Kabel gekoppelten Hochspannungsquelle, einer an ein Ende des Kabels angeschlossenen Auskoppeleinheit und einem über eine Sensoreinheit mit der Auskoppeleinheit verbundenen und aus den Sensorsignalen bei Vorhandensein eine Teilentladung ermittelnden Datenverarbeitungssystem. Dies erfolgt durch Erkennung von Ereignissen, Parametrisierung der als Impulse erkannten Ereignisse, Paarbildung der als Impulse erkannten und parametrisierten Ereignisse, Klassifikation der Ereignispaare, Zuordnung einer Teilentladung aus der Klassifikation und Bestimmung des Ortes der Teilentladung/en aus der Laufzeitdifferenz zwischen der jeweiligen Teilentladung und ihrer zugehörigen Reflexion.

Die Erfinder haben die Nachteile dieser auf extern anzubringenden Mitteln basierenden Fehlerortungsmethoden erkannt. So ist insbesondere die Anbringung für eine korrekte Strommessung ungenau und in der Sensitivität beschränkt.

Einem Aspekt dieser Offenbarung liegt die Aufgabe zugrunde, eine Vorrichtung und ein Verfahren für eine einfach durchzuführende, beispielsweise auch begleitend zu einem Kabelprüfvorgang durchführbare, Fehlervorortung anzugeben. Insbesondere wurden Vorteile einer bereits bei der Prüfung durchführbaren Fehlerortung erkannt, durch die ein Wachstum der Fehlstelle reduziert oder vermieden werden kann, wenn die Fehlervorortung bereits vor einem Durchschlag abgeschlossen werden kann. Eine derartige Diagnose ohne erzwungenen Durchschlag kann die Isolation eines teilweise defekten Kabels zum Teil erhalten, den Austausch des defekten Kabels verzögern und insbesondere Zeit ersparen, wenn Prüfung und Diagnose gleichzeitig vorgenommen werden können.

Einem weiteren Aspekt dieser Offenbarung liegt die Aufgabe zugrunde, einen kompakten und kostengünstigen Aufbau eines Prüfgeräts zu Prüfung eines Hoch- oder Mittelspannungskabels bereitzustellen, welcher sichere, einfache und kostengünstig durchzuführende Prüfverfahren ermöglicht.

Zumindest eine dieser Aufgaben wird gelöst durch ein Prüfgerät zur Prüfung eines Hoch- oder Mittelspannungskabels nach Anspruch 1 und durch ein Verfahren nach Anspruch 11. Weiterbildungen sind in den Unteransprüchen angegeben.

In einem Aspekt weist ein Prüfgerät zur Prüfung eines Hoch- oder Mittelspannungskabels, insbesondere mittels eines Very-Low-Frequency (VLF)-Prüfverfahrens, eine Schaltungs-anordnung. Diese umfasst eine Prüfspannungserzeugungseinheit, die einen niederspannungsseitigen Erdungseingang und einen hochspannungsseitigen Ausgang umfasst und zur Bereitstellung einer variablen Prüfspannung am hochspannungsseitigen Ausgang ausgebildet ist, einen Stromanschluss zum Anschließen der Prüfspannungserzeugungseinheit an eine Versorgungsspannungsquelle, einen Prüflinganschluss zum Verbinden des hochspannungsseitigen Ausgangs mit einem Leiter des Hoch- oder Mittelspannungskabels, insbesondere über ein Messanschlusskabel, und einen Schutzerdeanschluss zum Verbinden mit Schutzerde. Diese umfasst ferner einen Verbindungsleiter, der den niederspannungsseitigen Erdungseingang mit dem Schutzerdeanschluss elektrisch verbindet, sodass der Verbindungsleiter einen Stromsammelpunkt darstellt, der bei der Prüfung des Hoch- oder Mittelspannungskabels von einem Messstrom durchflossen wird, der sich zwischen dem niederspannungsseitigen Erdungseingang und einem ebenfalls an Schutzerde angeschlossenen Schirm des Hoch- oder Mittelspannungskabels ausbildet, sowie einen niederfrequenten Signalabgriff am Stromsammelpunkt, an dem basierend auf dem Messstrom ein niederfrequentes Diagnosesignal erzeugt wird, und einen hochfrequenten Signalabgriff am Stromsammelpunkt, an dem basierend auf dem Messstrom ein hochfrequentes Vorortungssignal für eine Messung einer transienten hochfrequenten Schwingung erzeugt wird. Ferner umfasst das Prüfgerät eine Auswerteelektronik, die mit dem niederfrequenten Signalabgriff zur Aufnahme des niederfrequenten Diagnosesignals verbunden und für eine VLF-Phasendrehungsmessung ausgebildet ist und die mit dem hochfrequenten Signalabgriff zur Aufnahme des hochfrequenten Vorortungssignals verbunden und für eine Fehlerabstandsauswertung ausgebildet ist.

In einem weiteren Aspekt weist ein Verfahren zur Prüfung eines Hoch- oder Mittelspannungskabels, insbesondere unter Verwendung eines hierin offenbarten Prüfgeräts die folgenden Schritte auf:
- Anschließen eines Leiters des Hoch- oder Mittelspannungskabels an einen Prüflinganschluss des Prüfgeräts, wobei ein Schirm des Hoch- oder Mittelspannungskabels mit Schutzerde verbunden ist,
- Erzeugen einer Very-Low-Frequency (VLF)-Prüfspannung mit einer Prüfspannungserzeugungseinheit des Prüfgeräts und Einkoppeln der VLF-Prüfspannung in das Hoch- oder Mittelspannungskabel,
- Messen einer transienten hochfrequenten Schwingung mit einem hochfrequenten Signalabgriff an einem Stromsammelpunkt der Hochspannungsquelle, wobei basierend auf einem durch den Stromsammelpunkt fließenden Messstrom ein hochfrequentes Vorortungssignal erzeugt wird, und
- Auswerten des hochfrequenten Vorortungssignals in einer Auswerteelektronik des Prüfgeräts hinsichtlich eines Fehlerabstands.

In einem weiteren Aspekt weist ein Verfahren zur Prüfung eines Hoch- oder Mittelspannungskabels, insbesondere unter Verwendung eines hierin offenbarten Prüfgeräts die folgenden Schritte auf:
- Bewirken eines Messtroms mit einer Prüfspannungserzeugungseinheit bei angeschlossenem Hoch- oder Mittelspannungskabel in einem Verbindungsleiter, der einen niederspannungsseitigen Erdungseingang der Prüfspannungserzeugungseinheit über einen Schutzerdeanschluss mit Schutzerde verbindet, wobei der Verbindungsleiter einen Stromsammelpunkt darstellt, der vom Messstrom durchflossen wird, und der Messstrom sich zwischen dem niederspannungsseitigen Erdungseingang und eines ebenfalls an Schutzerde angeschlossenen Schirms des Hoch- oder Mittelspannungskabels ausbildet,
- Erzeugen eines dem Messstrom zugeordneten niederfrequenten Diagnosesignals für eine VLF-Phasendrehungsmessung mit einem niederfrequenten Signalabgriff am Stromsammelpunkt,
- Erzeugen eines dem Messstrom zugeordneten hochfrequenten Vorortungssignals für eine Fehlerabstandsauswertung mit einem hochfrequenten Signalabgriff am Stromsammelpunkt, wobei das hochfrequente Vorortungssignal kontinuierlich während der VLF-Phasendrehungsmessung erzeugt wird, und
- Auswerten des hochfrequenten Vorortungssignals in einer Auswerteelektronik hinsichtlich eines Fehlerabstands.

In einigen Ausführungsformen des Prüfgeräts kann die Schaltungsanordnung dazu eingerichtet sein, mit der variablen Prüfspannung gleichzeitig das niederfrequente Diagnosesignal für eine Isolationsprüfung des Hoch- oder Mittelspannungskabels über die VLF-Phasendrehungsmessung und das hochfrequente Vorortungssignal für eine Fehlervorortung über die Messung transienter hochfrequenter Schwingungen zu erzeugen. Alternativ oder zusätzlich kann der niederspannungsseitigen Erdungseingang nur über den Verbindungsleiter mit Schutzerde verbindbar sein.

In einigen Weiterbildungen kann der hochfrequente Signalabgriff eine elektrische und/oder magnetische Kopplung mit dem Verbindungsleiter umfassen und die Kopplung zur Erfassung des Vorortungssignals mit Frequenzen im Bereich von 20 kHz bis 2 MHz mit einer Abtastrate mit Frequenzen im Bereich von 1 MHz bis mehreren 100 MHz ausgebildet sein. Die Kopplung kann als eine induktive Kopplung, insbesondere über eine Spule wie eine Rogowski-Spule oder (Luft-) Spule mit oder ohne induktiven Kern ausgebildet sein. Ferner kann der hochfrequente Signalabgriff dazu eingerichtet sein, kontinuierlich eine hochfrequente Stromschwingung im Verbindungsleiter zu erfassen. Die hochfrequente Stromschwingung kann insbesondere bei einem Durchschlag der Isolation im Hoch- oder Mittelspannungskabel oder eine mit einem bevorstehenden Durchschlag in Zusammenhang stehende hochfrequente Stromschwingung erfassbar sein.

In einigen Ausführungsformen des Prüfgeräts kann die Auswerteelektronik dazu eingerichtet sein,
- aus dem Vorortungssignal eine (oder mehrere) der hochfrequenten Stromschwingung zugeordnete Abstandsgröße(n) abzuleiten,
- die Abstandsgröße(n) hinsichtlich einer Plausibilität unter Berücksichtigung eines bekannten Parameters des Hoch- oder Mittelspannungskabels, insbesondere einer Länge des Hoch- oder Mittelspannungskabels, zu bewerten, und
- eine dem Hoch- oder Mittelspannungskabel zugeordnete Fehlerabstandsgröße auszugeben.

In einigen Ausführungsformen des Prüfgeräts kann die Prüfspannungserzeugungseinheit die Prüfspannung für eine Tangens-Delta-Messung erzeugen. Der niederfrequente Signalabgriff kann dazu eingerichtet sein, einen Momentanwert einer Stromstärke im Verbindungsleiter zu erfassen. Insbesondere kann sie eine Impedanz im Verbindungsleiter, insbesondere eine Parallelschaltung aus Widerstand und Kondensator, umfassen.

In einigen Weiterbildungen kann die Auswerteelektronik dazu eingerichtet sein, aus dem Diagnosesignal einen dem Hoch- oder Mittelspannungskabel zugeordneten Verlustfaktor zu bestimmen, und insbesondere zur Erfassung niedriger Frequenzen des Diagnosesignals im Bereich von 0.01 Hz bis 1 Hz mit einer Abtastrate mit Frequenzen im Bereich von 500 Hz bis 10 kHz ausgelegt ist.

In einigen Weiterbildungen kann die Auswerteelektronik mindestens eine analoge und/oder digitale Signalverarbeitungseinheit und/oder einen Prozessor und/oder einen Buffer-Speicher umfassen.

In einigen Ausführungsformen kann das Prüfgerät ferner eine Steuerungseinheit mit einem Speicher und einer Anzeige umfassen, wobei die Steuerungseinheit mit der Auswerteelektronik verbunden ist und dazu eingerichtet ist, eine Fehlerabstandsgröße im Speicher abzulegen, auf der Anzeige auszugeben und/oder eine Fehlerabstandsgröße als Steuerungsparameter zur Steuerung des Prüfgeräts, insbesondere für einen Abbruch einer VLF-Prüfung, zu verwenden.

In einigen Ausführungsformen kann das Prüfgerät ferner ein Gehäuse umfassen, in dem die Schaltungsanordnung und die Auswerteelektronik und optional eine Steuerungseinheit angeordnet sind.

In einigen Ausführungsformen des Verfahrens kann der Prozessor zum Identifizieren der Mehrzahl von dominanten Schwingungen eine diskrete Fouriertransformation auf den Messdatensatz anwenden und einen transformierten Messdatensatz im Frequenzbereich erzeugen, mindestens eine dominante Schwingungsfrequenz erkennen, die mindestens eine dominante Schwingungsfrequenz in den Zeitbereich zurücktransformieren und als mindestens eine dominante Schwingung für das Korrelieren mit dem zwischengespeicherten Messdatensatz ableiten.

In einigen Ausführungsformen des Verfahrens kann der Prozessor zum Identifizieren der Mehrzahl von dominanten Schwingungen eine kontinuierliche Wavelet-Transformation auf den Messdatensatz anwenden, mindestens eine dominante Ausprägung im Spektrum erkennen, die mindestens eine dominante Ausprägung in den Zeitbereich überführen und als mindestens eine dominante Schwingung für das Korrelieren mit dem zwischengespeicherten Messdatensatz ableiten.

In einigen Ausführungsformen des Verfahrens kann das hochfrequente Vorortungssignal derart hinsichtlich eines Fehlerabstands ausgewertet werden, dass für eine Grundschwingung, deren Plausibilität über einem Schwellwert liegt, eine Fehlerabstandsgröße berechnet wird. Zusätzlich oder alternativ können der Grundschwingung zugeordnete Parameter wie Schwingungsfrequenz, Periodizität und Qualitätsangabe und/oder die Fehlerabstandsgröße in einem Speicher abgelegt werden, in einem Messprotokoll abgespeichert werden, auf einer Anzeige ausgegeben werden und/oder einer Steuerung des Prüfgeräts als Steuerungsparameter, insbesondere für ein einen Abbruch einer VLF-Prüfung, zugeführt werden.

Insbesondere wird hierin ein VLF-Prüfgerät offenbart, das zusätzlich zur Tangens-Delta-Messung eine integrierte Fehlervorortungsmessung erlaubt, die in Form eines kontinuierlichen Samplings von HF-Daten im Frequenzbereich von z. B. 0,01 MHz bis 1 MHz (entsprechend Fehlerdistanzen im Bereich von z. B. 10 km bis 40 m) mit Sampling-Raten bis zu 2 MHz und mehr (z. B. 4 MHz) durchgeführt wird und keine vorausgehende Durchschlagserkennung benötigt. Ein Zielkernbereich der Fehlervorortung liegt üblicherweise im Bereich von 100 m bis 10 km. Aufgrund der unterschiedlichen Messsignale ist somit die für die Fehlervorortungsmessung benötigte Bandbreite von der Tangens-Delta-Messung spektral entkoppelt. Sie erfolgt in einem eigenständigen Signalabgriff und unterliegt einer spezifischen Signalauswertung, die keine Durchschlagserkennung voraussetzt.

Wie die Tangens-Delta-Messung kann die Fehlervorortungsmessung an einem Potential niedriger Spannung (vorzugsweise nahe Schutzerdepotential) - im VLF-Prüfgerät - erfolgen. Im Gegensatz zur Auskopplung von Signalen im Hochspannungspfad ist in diesem Fall keine räumlich voluminöse Ausdehnung einer Messvorrichtung notwendig.

Die hierin beschriebenen Konzepte können unter anderem folgende Vorteile gegenüber dem Stand der Technik aufweisen bzw. entsprechende Nachteile des Standes der Technik vermeiden:

Eine Fehlerortung mittels der externen Vorortungsmethode gemäß dem Stand der Technik kann hohe Kapazitäten einsetzen, die an das Kabel entladen werden, um eine Fehlerstelle zu zünden und die Schwingung auszulösen. Die Entladung derartig hoher Energien kann die Fehlerstelle und die angrenzenden Bereiche zusätzlich zum bereits vorliegenden Fehler weiter beschädigen oder zerstören.

Eine der Schwächen des Stands der Technik in Bezug auf die Methode ist, dass die Auswertung meist im Zeitbereich erfolgt. Die entstehende Schwingung besteht jedoch oft aus einem Signal mit vielen Oberwellen und störenden Signalanteilen.

Bei einer externen Vorortungsmethode gemäß dem Stand der Technik wird die Spannungslimitierung durch große Komponenten begrenzt; so wird üblicherweise eine Fehlerortung im Stand der Technik mit Maximalspannungen von z. B. 32 kV oder 40 kV limitiert, da ansonsten die Kondensatoren zur Entladung an das Kabel unproportional groß werden.

Im hierin beschriebenen neuen Ansatz werden derartig große Kondensatoren nicht benötigt, sondern es kann die vorhandene Kapazität des Kabels selbst genutzt werden. Somit ist ein sekundäres Zerstörungsrisiko reduziert und die einzusetzende Spannung ist nicht limitiert. Mit anderen Worten kann die maximale Prüfspannung des Generators ausgenutzt werden. Ein weiterer Vorteil ergibt sich in der Ausnutzbarkeit der Eigenschaft, dass die Energie in einem kapazitiven Element (wie einem Kabel) quadratisch zur Spannung steigt und mit höheren Durchbruchspannungen auch besser erfassbare Schwingungen ausgelöst werden können.

Bei einer externen Vorortungsmethode gemäß dem Stand der Technik wird bei der Fehlerortung mittels Kondensatoren oder eingebauter Durchschlagserkennung auf einen Trigger-Impuls gewartet, der eine Auswertung anstößt. Dies wird von dem Nachteil begleitet, dass im ersten Moment aufgrund der sogenannten Zündverzögerung (verursacht durch die nötige Aufladung des Anschlusskabels) nicht eindeutig ist, ob nur die Entladung des Kondensators oder schon ein Durchschlag den Strom treibt. Mit anderen Worten kann bereits ein Strom fließen, der eine Auswertung aktiviert, aber ein Funke, der die zu erfassende gewünschte Schwingung auslöst, hat sich noch gar nicht ausgebildet. Dieser Umstand erfordert im Stand der Technik eine gute Auswertekenntnis des Bedieners.

Bei der integrierten Auswertung nach dem hierin beschriebenen neuen Ansatz entfällt der Bedarf einer Durchschlagserkennung, da das zu prüfende Kabel intrinsisch durch die stattfindende VLF-Prüfung aufgeladen wird (es tritt keine Zündverzögerung ein) und erfasste Schwingungen laufend abgetastet, ausgewertet und auf Plausibilität bewertet werden können. Beispielsweise kann bei Auftreten einer auswertbaren Schwingung diese abgespeichert und weiterverarbeitet werden, während die Abtastung bereits wieder aktiv durchgeführt wird. Somit kann auf einen Trigger-Mechanismus, der explizit den Start eines Durchschlages signalisiert, verzichtet werden.

Bei einer externen Vorortungsmethode gemäß dem Stand der Technik können fehlerhafte Trigger-Ereignisse eintreten. Mit anderen Worten besteht bei Verfahren nach dem Stand der Technik jeweils die Schwierigkeit, die Durchschlagserkennung in einen der Aussteuerung entsprechenden, messtechnisch gut erfassbaren Bereich zu schalten. Je nach Stromstärke muss unter Umständen die Fehlerortung (manuell oder automatisch) mehrfach erfolgen, damit eine geeignete Aussteuerung für die externen Vorortungsmethode gemäß dem Stand der Technik ermittelt werden kann.

Im hierin beschriebenen neuen Ansatz ist der Aufbau des VLF-HV-Generators derart, dass der Strom zwingend am Strom-Sammelpunkt positiv wie negativ schwingt; daher kann der Strom induktiv in einem sehr weiten Strombereich erfasst werden, ohne dass eine Aussteuerungsanpassung mit mehreren Durchschlägen notwendig wird, da ein magnetischer Sättigungseffekt weitgehend verhindert werden kann.

Eine weitere Schwäche der Auswertemethoden gemäß dem Stand der Technik liegt ferner darin, dass die Auswertung meist im Zeitbereich erfolgt. Die entstehende Schwingung besteht jedoch aus einem Signal mit vielen Oberwellen und störenden Signalanteilen.

Im hierin beschriebenen neuen Ansatz wird eine Methode umgesetzt, die es ermöglicht, auch überlagerte Schwingungen in einem Signal zu erkennen, wie es z. B. im Fall eines kurzen Funkens oder bei Mehrfachdurchschlägen auftreten kann. Dadurch wird die Qualität in der Beurteilung der Auswertung erhöht.

Hierin werden Konzepte offenbart, die es erlauben, zumindest teilweise Aspekte aus dem Stand der Technik zu verbessern. Insbesondere ergeben sich weitere Merkmale und deren Zweckmäßigkeiten aus der folgenden Beschreibung von Ausführungsformen anhand der Figuren. Von den Figuren zeigen:
- Fig. 1: eine schematische Darstellung eines beispielhaften Prüfgeräts zu Prüfung eines Hoch- oder Mittelspannungskabels gemäß dem erfinderischen Konzept,
- Fig. 2: eine schematische Darstellung einer beispielhaften Schaltungsanordnung in einem Prüfgerät zur Prüfung eines Hoch- oder Mittelspannungskabels,
- Fig. 3: ein Flussdiagramm eines beispielhaften Ablaufs einer Prüfung von Isolationen in Koaxialkabeln,
- Fig. 4: ein Flussdiagramm zur Erläuterung eines beispielhaften Messvorgangs gemäß dem erfinderischen Konzept,
- Fig. 5: ein schematisches Flussdiagramm zur Erläuterung beispielhafter Umsetzungen zur Grundschwingungsidentifikation,
- Fig. 6: ein Messdatensatz eines beispielhaften erfassten Vorortungssignals einer Messung,
- Fig. 7: eine Skizze zur Verdeutlichung einer beispielhaften Auswertung und Korrelation im Zeitbereich und
- Fig. 8: eine Skizze zur Verdeutlichung einer beispielhaften Auswertung im Frequenzbereich.

Die Erfinder haben erkannt, dass ein VLF-Prüfgerät für die Lokalisierung eines Fehlers in einem Prüfling genutzt werden kann. Im Speziellen kann durch eine Erweiterung eines VLF-HV-Generators, der bereits eine integrierte Tangens-Delta-Diagnose-Funktion aufweist, parallel zur Tangens-Delta-Prüfung und Diagnose hinsichtlich eines möglichen Fehlers im Prüfling eine Datenerfassung und Auswertung zur Fehlerdistanzbestimmung erfolgen. Sollte es zu einem Durchschlag in der Isolation kommen oder gegebenenfalls auch in einer Vorphase eines Durchschlags, kann somit zugleich zur Tangens-Delta-Prüfung eine Auswertung zur Fehlerdistanzbestimmung vorgenommen werden. Für die Fehlervorortung wird zusätzlich zum während der VLF-Prüfung erfassten niederfrequenten Diagnosesignal für die Tangens-Delta-Diagnose eine hochfrequente Schwingung in Form eines hochfrequenten Vorortungssignals erfasst, wobei zweiteres Signal in Zusammenhang mit einer Fehlstelle, insbesondere bei Eintreten eines Durchschlags, ausgelöst werden kann. Kann der Schwingung eine "richtige" Schwingungsfrequenz zugeordnet werden, so ist die zugehörige Periodizität proportional zur Entfernung der Fehlerstelle entlang des Kabels.

Dabei nutzen die Erfinder insbesondere die Tatsache, dass in einem VLF-HV-Generator die Strommessung bereits an einem Sammelpunkt erfolgt. Kommt es während einer VLF-Prüfung an einem Energiekabel zu einem Fehler (beispielsweise ein Durchschlag), so wird auch die sich ergebende Schwingung zwingend durch diesen Sammelpunkt verlaufen. Am Sammelpunkt kann ein Signal der Schwingung beispielsweise induktiv/magnetisch mittels einer Spule (z. B. Rogowski- oder auch Luft-Spule mit oder ohne induktiven Kern, beispielhafte Induktivitäten von 0,1 µH bis 10 µH, insbesondere 1 µH bis 6 µH, und einer Bandbreite von mehreren MHz) oder alternativ spannungsmäßig über ein Stromshunt erfasst werden. Da der Stromsammelpunkt nur intern im VLF-HV-Generator vorliegt, bietet dieser Ort gleichermaßen die Möglichkeit den Messstrom für die Tangens-Delta-Diagnose, als auch für die Fehlerortung zu verwenden.

Somit basiert die Erfindung ferner auf der Erkenntnis in Bezug auf den Abgriff des Schwingungssignals. Denn das Schwingungssignal kann eben nicht einfach z. B. am Hochspannungsanschlusskabel abgegriffen werden, da der Strom über mehrere Schutzerdebezogene Verbindungen zirkulieren kann, sodass bei einem dortigen Abgriff die Auflösung nicht ausreichend sein kann oder entsprechend höhere Impulsströme zu generieren wären, um ein messbares Schwingungssignal zu erreichen.

Die hierin beschriebenen Konzepte zur Fehlervorortung sind insbesondere dahingehend einzigartig, dass durch die geschickte Positionierung der Schwingungserfassung im Strom-Messpfad eines VLF-HV-Generators (d. h. am Stromsammelpunkt) die Möglichkeit entsteht, bei einem Durchschlag schon während der Prüfung direkt auf eine Distanz zur Fehlerstelle schließen zu können.

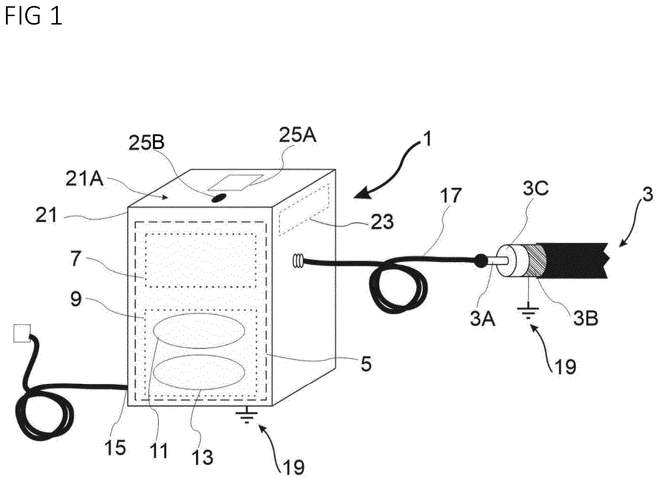

Fig. 1 zeigt eine schematische Darstellung eines portablen Prüfgeräts 1 zu Prüfung eines Prüflings 3, z. B. ein Hoch- oder Mittelspannungskabels wie einem Koaxialkabel, gemäß dem erfinderischen Konzept. Das Prüfgerät 1 umfasst eine Schaltungsanordnung 5, im Wesentlichen eine VLF- Prüfspannungserzeugungseinheit 7 zur Erzeugung einer geeigneten (VLF-) Prüfspannung, und eine mit der Schaltungsanordnung 5 gekoppelte und in das Prüfgerät integrierte (Mess- und) Auswerteelektronik 9. Die Auswerteelektronik 9 ist sowohl für eine Tangens-Delta-Messung (Tangens-Delta-Mess-Einheit 11) als auch für eine Fehlervorortung (Fehlervorortungseinheit 13) eingerichtet. Die der Auswerteelektronik 9 zugrundeliegende Hardware (Recheneinheit) weist beispielsweise digitale Prozessorsysteme mit Dateneingänge und Steuerungsausgänge aufweisenden Mikroprozessorkreisen auf, die gemäß computerlesbaren auf einem computerlesbaren Medium gespeicherten Anweisungen betrieben werden. Üblicherweise umfasst die Auswerteelektronik 9 eine hohe Rechenleistung für eine Echtzeitanalyse der fortlaufend erfassten und auszuwertenden Datensätze sowie Langzeit-(nicht volatilen) Speicher zum Speichern der Programmanweisungen als auch sehr schnellen Kurzzeit- (volatilen) Speicher zum Speichern von erfassten Daten und Auswertungsergebnissen während (oder sich ergebend aus) der nachfolgend beschriebenen Datenerfassung und der Datenverarbeitung von nieder- und/oder hochfrequenten Signalen.

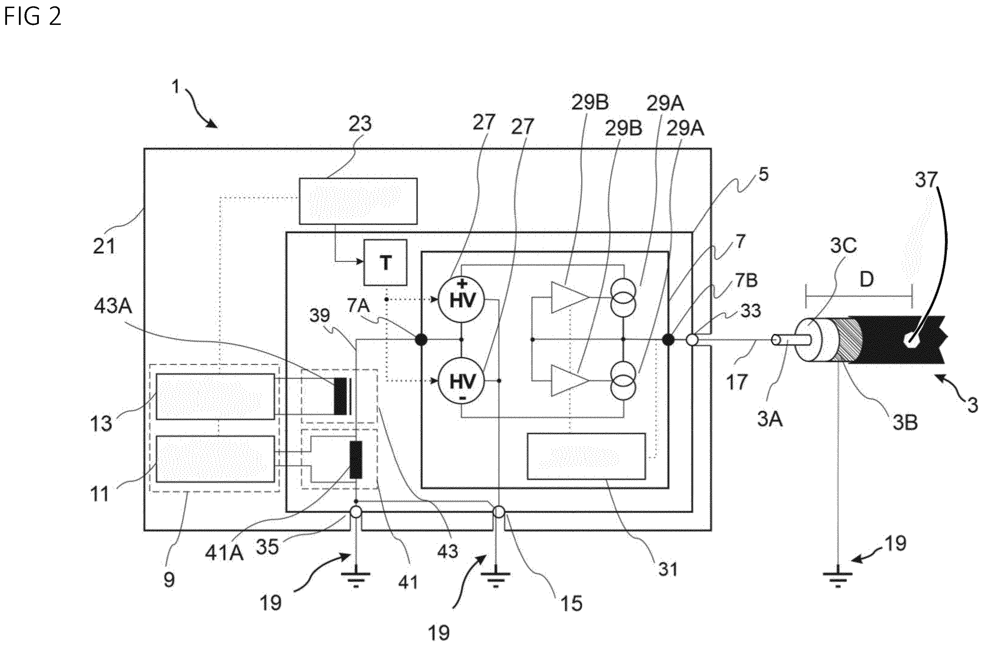

Das Prüfgerät 1 wird über beispielsweise das Stromnetz (allgemein einer Versorgungsspannungsquelle) mit Energie versorgt (Stromanschluss 15). Ein Leiter 3A des Prüflings 3 ist an das Prüfgerät 1 über ein (HV-) Anschlusskabel 17 (mit beispielhaften Längen von 5 m bis 15 m) angeschlossen. Ein Schirm 3B des Prüflings 3 wie auch die Schaltungsanordnung 5, wie nachfolgend genauer erläutert, sind an Schutzerde 19 angeschlossen, wobei auch der Stromanschluss 15 eine Schutzerde 19 mitführen kann (siehe auch Fig. 2). Zwischen dem Leiter 3A des Prüflings 3 und dem Schirm 3B liegt eine zu prüfende Isolation 3C.

Die Schaltungsanordnung 5 ist in einem Gehäuse 21 des Prüfgeräts 1 angeordnet und kann elektronische Komponenten wie eine Signalverarbeitung mit Operationsverstärkern, zumindest einem Integrator, einem Sample and Hold-Glied, zumindest einem Analog-Digital-Wandler zur Digitalisierung für die weitere Verarbeitung in einem Prozessor, der mindestens einen Speicher zur Ablage von Sampling-Daten (Messdaten) hat, umfassen. Die Schaltungsanordnung 5 kann ferner mit einer im Prüfgerät 1 oder ganz oder teilweise außerhalb des Prüfgeräts 1 vorgesehenen Steuerung 23 des Prüfgeräts 1 verbunden oder (teilweise) in diese integriert sein. Diese wiederum generiert gemeinsam mit den in der Schaltungsanordnung 5 enthaltenen Hochspannungsquellen eine Prüfspannung, indem sie z. B. über einen Transformator und nachgeschalteter Kaskaden-Vervielfacher die Leistung für die zur Regelung der Prüfspannung benötigten Stromquellen zur Verfügung stellt.

Auf der Oberseite 21A des Gehäuses 21 sind ein Bedienanzeige 25A (Display) zur Anzeige der gewonnen Prüfdaten und wenigstens ein Bedienelement 25B zur Einstellung eines Messparameters vorgesehen (schematisch in Fig. 1 angedeutet). Die Bedienanzeige 25A und das Bedienelement 25B bilden beispielsweise ein User-Interface der Steuerung 23.

Fig. 2 zeigt eine beispielhafte Schaltskizze für die Schaltungsanordnung 5 des in Fig. 1 dargestellten Prüfgeräts 1 mit dem über des Anschlusskabel 17 angeschlossenen Prüfling 3. In der Schaltungsanordnung 5 umfasst die Prüfspannungserzeugungseinheit 7 beispielhaft zwei Hochspannungsquellen 27, welche über den Stromanschluss 15 mit Energie versorgt werden und dazu eingerichtet sind, an ihren jeweiligen Ausgängen, eine positive (+) bzw. negative (-) Hochspannung variabler Amplitude bereitzustellen, indem beispielsweise eine Modulation mit einem Vielfachen der Netzfrequenz betrieben wird. Zwischen den Ausgängen der beiden Hochspannungsquellen 27 und dem Prüfling 3 ist eine Hochspannungsschalteranordnung 29 vorgesehen, auf welche mittels einer Regelung 31 zur definierten Auf- und Entladung des eine gewisse kapazitive Last darstellenden Prüflings 3 eingewirkt wird. Die Regelung 31 ist dazu eingerichtet, einen, vorzugsweise sinusförmigen, Spannungsverlauf am Prüfling 3 zu gewährleisten.

In der beispielhaft in Fig. 2 gezeigten Ausführungsform umfasst die Hochspannungsschalteranordnung 29 z. B. zwei Halbleiterschalterkaskaden 29A mit je einem Verstärker 29B, auf welche die Regelung 31 einwirkt. Ferner werden die Hochspannungsquellen 27 von der Steuerung 23 mithilfe eines Taktsignalgebers T angesteuert, sodass die zwei Hochspannungsquellen 27 jeweils eine anhand des Taktsignalgebers T synchronisierte, in Kurvenform und Amplitude definiert vorgebbare, vorteilhaft kantenfreie und insbesondere sinusförmige, und nicht durch die Regelung 31 beeinflusste Prüfspannung bereitstellen können.

Für weitere Details zur Erzeugung und Regelung der Prüfspannung wird beispielsweise auf die eingangs genannten DE 10 2012 024 560 B3 und DE 195 13 441 A1 verwiesen.

Wesentlich für die hierin beschriebenen Konzepte ist, dass die Prüfspannungserzeugungseinheit 7 einen niederspannungsseitigen Erdungseingang 7A und einen hochspannungsseitigen Ausgang 7B umfasst. Der Ausgang 7B ist elektrisch mit einem Prüflinganschluss 33 verbunden, an den der Leiter 3A des Prüflings 3 zur Prüfung elektrisch angeschlossen wird. Die Prüfspannungserzeugungseinheit 7 wird am niederspannungsseitigen Erdungseingang 7A über einen Schutzerdeanschluss 35 geerdet (internes Erdpotential im Betrieb). Beim zu prüfenden Kabel und insbesondere für die Prüfung ist auch der Schirm 3B (Mantel) des Prüflings 3 mit Schutzerde verbunden, sodass der Schirm 3B und das VLF-Prüfgerät 1, insbesondere die Prüfspannungserzeugungseinheit 7, auf einer gemeinsamen Schutzerde liegen. Insbesondere bei der Prüfung von im Erdreich verlegten Hoch- oder Mittelspannungskabeln liegt der Schirm 3B am Anfang und am Ende auf Erdpotential (Schutzerde 19). Bei einem Defekt 37 im Prüfling 3 kann sich, wird der Schutzerdeanschluss 35 mit dem gleichen Erdpotential (Schutzerde 19) verbunden, ein elektrischer Kreis ausbilden, durch den ein Messstrom fließen kann und der sich von der Prüfspannungserzeugungseinheit 7 über den Prüfling 3, insbesondere den Defekt 37, und durch den Schutzerdeanschluss 35 über den Erdungseingang 7A zurück zur Prüfspannungserzeugungseinheit 7 erstreckt.

Der Messstrom ist an einem Verbindungsleiter 39, der den niederspannungsseitigen Erdungseingang 7A mit dem Schutzerdeanschluss 35 (interne Erdpotential im Betrieb) elektrisch verbindet, für eine Messung innerhalb des Prüfgeräts 1 und in einer Niederspannungsumgebung zugänglich. Der Verbindungsleiter 39 stellt somit einen Stromsammelpunkt für die Messung des Messstroms dar und wird für einen niederfrequenten Signalabgriff 41, beispielsweise über eine Impedanz 41A, zur Erzeugung eines Diagnosesignals verwendet. Das Diagnosesignal wird im Rahmen einer analogen und/oder digitalen Signalverarbeitung in der Tangens-Delta-Messeinheit 11 zur Bestimmung der Phase und damit der Verlustleistung verwendet.

Die hierin beschriebenen Konzepte verwenden den Stromsammelpunkt nun auch für eine Fehlervorortung, bei der zur Erzeugung eines hochfrequenten Vorortungssignals ein hochfrequenter Signalabgriff 43, beispielsweise induktiv über eine Spule 43A, in der Niederspannungsumgebung des Verbindungsleiters 39 positioniert wird. Entlang dem Verbindungsleiter 39 kann der hochfrequente Signalabgriff 43 vor oder nach dem niederfrequenten Signalabgriffs 41 positioniert werden. Hintergrund ist, dass sich bei einem Durchschlag am Defekt 37 oder während des Ausbildens eines Durchschlags oder bei einer entsprechend energiereichen Teilentladung eine hochfrequente Schwingung ausbildet, deren Frequenz von einer Lage des Defekts 37 im Prüfling, insbesondere von einem Abstand D des Defekts 37 zum Prüflinganschluss 33 (verstanden vom Fachmann als durch eine Abstandsgröße des Fehlers/Defekts - Fehlerabstandsgröße - gegeben), abhängt. Informationen über diese hochfrequente Schwingung können über das hochfrequenten Vorortungssignal in der Auswerteelektronik 9, insbesondere mit einer analogen und/oder digitalen Signalverarbeitung in der Fehlervorortungseinheit 13, gewonnen werden. Die Informationen können in die Steuerung des Prüfgeräts 1 einfließen oder an einen Prüfer im Rahmen eines Messprotokolls ausgegeben/abgespeichert werden.

Informationen bezüglich der Fehlervorortung können laufend während der Tangens-Delta-Messung gewonnen werden, da das hochfrequente Vorortungssignals kontinuierlich erfasst und bewerten werden kann. Die Bewertung umfasst beispielsweise eine Plausibilitätsprüfung auf sinnwolle Fehlerdistanzen, indem aus dem hochfrequenten Vorortungssignal Grundfrequenzen gewonnen werden, die mit der Kabellänge abgeglichen werden.

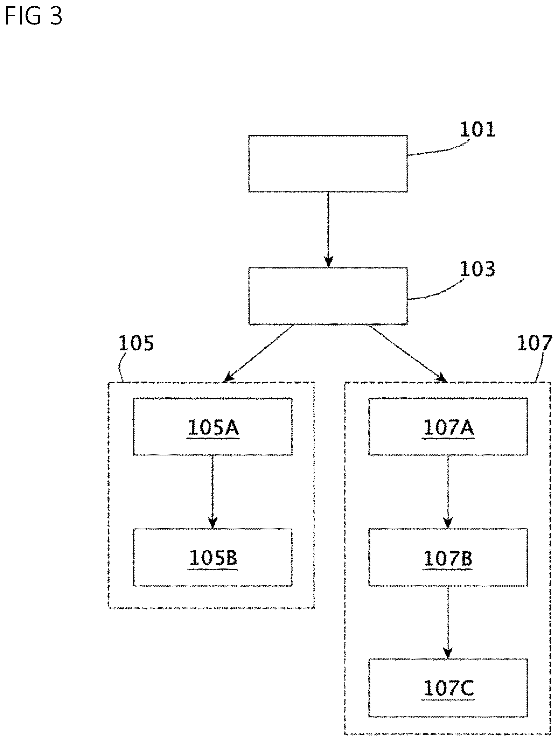

Fig. 3 verdeutlicht in einem Flussdiagramm den Ablauf einer Prüfung von Isolationen in z. B. Koaxialkabeln zur Strom-/Energieverteilung in elektrischen Versorgungsnetzen. Allgemein werden zur Prüfung und Diagnosemessung Informationen zur Isolation mittels einer Phasendrehungsmessung (Tangens-Delta-Messung) sowie einer Messung schneller (hochfrequenter), transienter Schwingungen während oder noch vor einem Durchschlag der Kabelisolation gewonnen und insbesondere zur Entfernungsberechnung (Vorortung) ausgewertet.

Für die Prüfung wird der Leiter 3A des Prüflings 3 an einen Prüflinganschluss 33 des Prüfgeräts 1 (beispielsweise über das Anschlusskabel 17) angeschlossen und der Schirm 3B des Prüflings 3 ist im montierten Zustand des Prüflings bzw. wird mit Schutzerde 19 verbunden (Schritt 101).

Die Prüfspannung, hier eine Very-Low-Frequency (VLF)-Prüfspannung, wird mit der (getakteten) Prüfspannungserzeugungseinheit 7 erzeugt und in den Prüfling 3 eingekoppelt (Schritt 103). Die Prüfspannung variiert mit einer Frequenz von 0,01 Hz bis 1 Hz sinusförmig bei einer Spannungsamplitude typischerweise im Bereich von 20 kVpeak bis 120 kVpeak, insbesondere von 40 kVpeak bis 100 kVpeak. Für die Erzeugung einer hochqualitativen Hüllkurve liefert der Taktsignalgeber T eine Zeitbasis zur Taktung der Hochspannungsquellen 27, sodass von Halbleiterschalterkaskaden 29A (als Stromquellen) über die Regelung 23 am Ausgang 7B der Prüfspannungserzeugungseinheit 7 die sinusförmige Prüfspannung erzeugt werden kann.

Die am Prüfling 3 angelegte Spannung setzt die zwischen Leiter 3A und Schirm 3B angeordnete Isolation 3C des Prüflings 3 einer definierten Feldstärke aus und ermöglicht die Prüfung der Isolation 3C. Um am Prüfling 3 die Spannung aufzubauen, fließt ausgehend von den Halbleiterschalterkaskaden 29A (als Stromquellen) ein geregelter Strom durch den Prüfling 3, der über die Schutzerde, insbesondere den Schutzerdeanschluss 35, zurück zur Prüfspannungserzeugungseinheit 7 (den Hochspannungsquellen 27) einen geschlossenen Stromkreis bildet.

Für eine Bestimmung des Verlustfaktors (Schritt 105) wird über eine Impedanz (als Beispiel eines niederfrequenten Signalabgriffs), vorzugsweise eine Parallelschaltung aus Widerstand und Kondensator, und mittels einer in der Auswerteelektronik 9 durchgeführten Signalverarbeitung ein Momentanwert der Stromstärke, ein Verlauf der Stromstärke und deren Phasenlage bestimmt und an die Steuereinheit weitergeleitet. Hierbei wird insbesondere ein dem Messstrom zugeordnetes niederfrequentes Diagnosesignal für eine Phasendrehungsmessung mit einem niederfrequenten Signalabgriff am Stromsammelpunkt erzeugt (Schritt 105A) und hinsichtlich der Phasenlage und des Verlustfaktors von der Auswerteeinheit ausgewertet (Schritt 105B). Die Bestimmung des Verlustfaktors und die zugrundeliegende Anordnung ist vorzugsweise zur Erfassung und Auswertung niedriger dem Messstrom zugeordneter Frequenzen im Bereich des Diagnosesignals 0,01 Hz bis 1 Hz ausgelegt. Beispielsweise liegt eine digitale Abtastrate bei Frequenzen im Bereich von 500 Hz bis10 kHz vor.

Für eine Fehlervorortung (Schritt 107) werden über eine induktive Kopplung (als Beispiel eines hochfrequenten Signalabgriffs) hochfrequente Schwingungen gemessen (Schritt 107A) und ein hochfrequentes Vorortungssignal erzeugt (Schritt 107B) und mittels einer in der Auswerteelektronik 9 durchgeführten Signalverarbeitung hinsichtlich eines Fehlerabstands ausgewertet (Schritt 107C). Insbesondere werden Ströme kontinuierlich und somit auch bei einem etwaigen Durchschlag der Isolation 3C im Prüfling 3 oder bereits vor dem Durchschlag erfasst und laufend auf Plausibilität entsprechend der bekannten Parameter des Prüflings 3 (wie die Länge) bewertet. Die induktive Kopplung ist vorzugsweise für dem Messstrom zugeordneter Frequenzen beim Durchschlag (transiente Welle, Schwingung) im Bereich von 20 kHz bis 2 MHz ausgelegt. Beispielsweise liegt eine digitale Abtastrate bei Frequenzen im Bereich von 1 MHz bis mehreren 100 MHz.

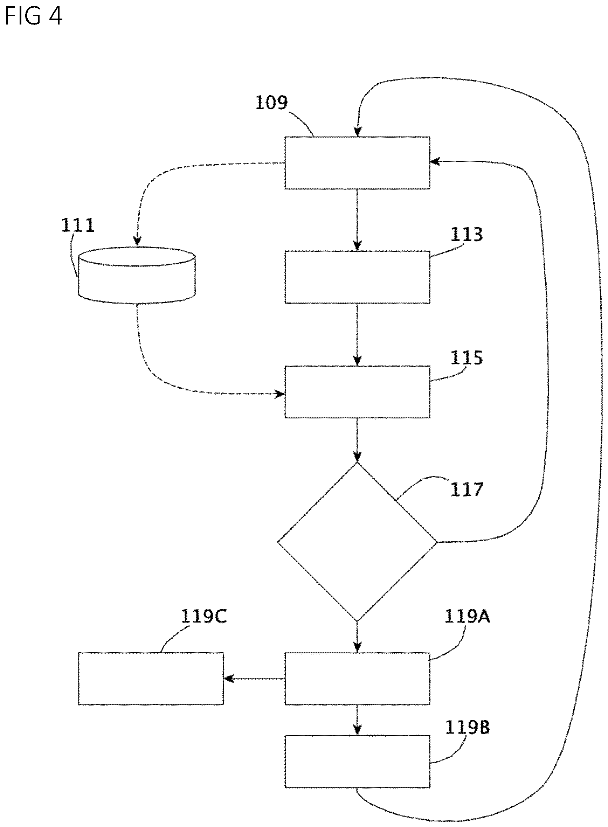

Wie in Fig. 4 in einem beispielhaften Flussdiagramm gezeigt wird, dient die Signalverarbeitung in Schritt 107C der Erkennung von Wanderwellen ("detection of traveling waves"). Die Signalverarbeitung beispielsweise eine laufende Abtastung des Fehlervorortungssignals, optional mit einem Fenstern des Vorortungssignals, (Schritt 109 - "permanent sampling and framing") und ein (Zwischen-) Speichern der sich fortlaufend ergebende Messdaten in einem beispielsweise zyklischen Speicher/Ringpuffer (Schritt 111 - "storing in cyclic buffer"). Durch die Fensterung kann z. B. ein Teilbereich des zyklisch erfassten Signals für die weitere Signalverarbeitung als Ausschnitt vorbereitet werden.

Ferner umfasst die Signalverarbeitung einen Identifikationsschritt (Schritt 113 - "identifying fundamtental waves"), in dem eine oder mehrere dominante Schwingungen und deren Parameter (wie Frequenz, Phasenlage und Amplitude, sowie Amplitudenverhältnis) aus dem Signal ermittelt werden können. Als Ergebnis kann der Identifikationsschritt Schwingungsdaten in einem Zeitberiech liefern, beispielsweise für einen rücktransformierten Zeitbereichsausschnitt, die für nachfolgende Bewertungsberechnungen herangezogen werden.

Beispielsweise kann zur Bewertung der Schwingungsdaten (insbesondere zur genauen Lagebestimmung der zu betrachtenden Schwingung im Zeitbereich) eine Korrelation von identifizierten dominanten Schwingungen mit den ursprünglichen Messdaten vorgenommen werden (Schritt 115 - "performing correlation of fundamtentals"), um die passendste (oder mehrere passende) Schwingung(en) auszuwählen oder zu bestätigen und vorzugsweise die bestmöglich zu den Messdaten passendste Schwingung zu identifizieren. Allgemein stellt eine Korrelation ein Maß der Übereinstimmung des Messignals mit der identifizierten Schwingung dar.

Schließlich kann mittels Parameter wie Kabellänge und Wellenausbreitungsgeschwindigkeit eine identifizierte dominante Schwingung auf Plausibilität hinsichtlich des Prüflings geprüft werden (Schritt 117 - "evaluating parameters of fundamentals"). Ist die Plausibilitätsprüfung erfolgreich (z. B. liegt die bestimmte Plausibilität über einem Schwellwert), stellt diese dominante Schwingung eine Grundschwingung dar, die auf eine Fehlstelle zurückgeht.

Ist eine passende Schwingung gefunden (liegt beispielsweise eine Plausibilität über einem Schwellwert), können die für die Schwingung ermittelten Parameter wie Schwingungsfrequenz, Periodizität und Qualitätsangabe (Amplitudengewichtung) beispielsweise von der Steuereinheit in einem Messprotokoll abgespeichert (Schritt 119B) und/oder auf der Anzeige ausgegeben (Schritt 119C) werden.

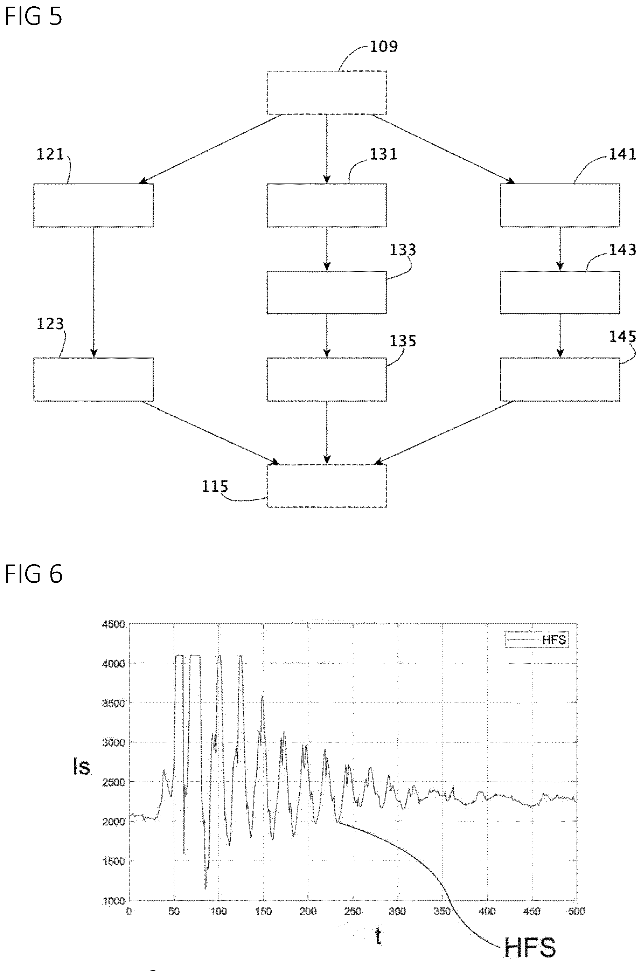

Fig. 5 zeigt in einem schematischen Flussdiagramm beispielhafter Umsetzungen zur Grundschwingungsidentifikation (Schritt 113 in Fig. 4). Die Grundschwingungsidentifikation geht von Schritt 109 aus, in dem z. B. in einem Ziel-Zeitfenster, welches der überwachten Kabellänge entspricht, permanent Messdaten im zyklischen Speicher digital erfasst werden, wobei für die Signalverarbeitung eine Fensterung durchgeführt werden kann.

Die permanente Auswertung kann zum Identifizieren einer dominanten Schwingung in einer ersten Variante (im Zeitbereich) fortlaufend Nulldurchgänge und/oder Spitzenwerte für die im zyklischen Speicher abgelegten Messdaten ermitteln (Schritt 121) und deren Positionen im Speicher (und/oder alternativ zugehörige Differenzwerte) notieren. Diese können beispielsweise als laufender Index-Stapel weitergeleitet und verarbeitet werden. Beispielsweise können aus dem Index-Stapel anhand der gegebenen Zeitbasis (Abtastrate) die zugrundeliegenden Frequenzen einer/mehrerer dominanter Schwingungen ("fundamentals") identifiziert werden (Schritt 123).

Wie in Zusammenhang mit Fig. 4 erläutert können die identifizierten Frequenzen anhand des zyklischen Speichers und den originalen Messdaten über eine Korrelation auf die bestmögliche Annäherung geprüft werden. Ist eine passende Grundfrequenz gefunden und entspricht diese den eingrenzenden Parametern des Prüflings, die aufgrund der zu erwartenden oder passenden Kabellänge gegeben sind, kann die identifizierte Grundfrequenz einem Messbericht hinzugefügt werden.

Allgemein ist es oft nicht trivial, eine Periodizität z. B. beim Nulldurchgang richtig einzugrenzen. Die nachfolgend beschriebenen Varianten der Fourieranalyse oder der spektralen Wavelet-Analyse können Schwächen der Auswertung im Zeitbereich vermeiden und störende Oberwellenanteile aus der Bewertung nehmen.

Die permanente Auswertung kann zum Identifizieren von mehreren dominanten Schwingungen in einer zweiten Variante (im Frequenzbereich) - ausgehend von Schritt 109 - das gefensterte Signal mittels einer diskreten Fouriertransformation in ein Frequenzspektrum zur Basis einer Sinusschwingung transformieren (Schritt 131 - "discrete Fourier transformation into frequency domain"). Im Frequenzbereich ergibt sich eine Gewichtung möglicher dominanter sinusförmiger Amplituden.

Eine Auswahl dominanter (Sinus-) Schwingungen (Schwingungsfrequenzen) kann anhand einer Amplitudenbewertung getroffen werden (Schritt 133 - "identifying one or more dominant frequencies in frequency domain"). Die identifizierten Frequenzen können rücktransformiert (Schritt 135 - "inverse Fourier transformation") und im Zeitbereich als dominante Schwingung (transient) dem Messsignal überlagert werden. Die identifizierten Frequenzen/dominanten Schwingungen können unter Verwendung der im zyklischen Speicher abgelegten Messdaten über eine Korrelation auf die bestmögliche Annäherung geprüft werden (Schritte 115 und 117 in Fig. 4). Ist eine passende Grundschwingung gefunden und entspricht diese den eingrenzenden Parametern des Prüflings, die aufgrund der zu erwartenden oder passenden Kabellänge gegeben sind, kann die identifizierte Grundschwingung dem Messbericht hinzugefügt werden.

Die permanente Auswertung kann zum Identifizieren von mehreren dominanten Schwingungen in einer dritten Variante (im "spektralen Bereich") - ausgehend von Schritt 109 - das gefensterte Signal mittels einer kontinuierlichen Wavelet-Transformation in ein Spektrum zur Basis erwarteter (typischer) und vordefinierter Wellenformen transformieren (Schritt 141 - "continuous Wavelet transformation"). Im Spektrum liegt eine relative Gewichtung möglicher dominanter Schwingungen vor (Musterabgleich).

Eine Auswahl dominanter Ausprägungen kann getroffen werden (Schritt 143 - "identifying one or more dominant matches in spectrum"), diese können in den Zeitbereich übergeführt werden (Schritt 145 - "transforming identified matches into time domain") und im Zeitbereich als eine dominante Schwingung (transient) dem Messsignal überlagert werden. Die identifizierten Frequenzen können unter Verwendung der im zyklischen Speicher abgelegten Messdaten über eine Korrelation auf die bestmögliche Annäherung geprüft werden (Schritte 115 und 117 in Fig. 4). Ist eine passende Grundfrequenz gefunden und entspricht diese den eingrenzenden Parametern des Prüflings, die aufgrund der zu erwartenden oder passenden Kabellänge gegeben sind, kann die identifizierte Grundfrequenz dem Messbericht hinzugefügt werden.

Die Identifikation von dominanten Grundschwingungen kann beispielsweise über eine der drei vorausgehend beschriebenen Methoden erfolgen. Diese können ergänzend zur Tangens-Delta-Messauswertung in der Recheneinheit des Prüfgeräts 1 (insbesondere in der Mess- und Auswerteeinheit 9 vorgesehen werden, wobei die Auswerteschritte auf einem oder mehreren Rechenmodulen umgesetzt werden kann.

Fig. 6 zeigt für einen beispielhaften Messdatensatz ein HF-Signal HFS (Signalstärke Is aufgetragen über Zeit t in einem Eingangssignalzeitausschnitt/Fensterung), das nach der Digitalisierung eines am hochfrequenten Signalabgriff erfassten Vorortungssignal im Zwischenspeicher abgelegt wurde. Man erkennt eine nach dem Durchschlag abklingende Grundschwingung im MHz-Frequenzbereich sowie zusätzliche höhere Frequenzanteile in Form von Modulationen der Grundschwingung. Das HF-Signal HFS kann einer Auswertung im Zeitbereich zugrunde gelegt werden. So können über eine Nulldurchgangs- oder Spitzenwertdetektion automatisch oder manuell (z. B. durch Cursorsetzung an einem angezeigten Graphen) eine oder mehrere Schwingungen über die zeitliche Differenz von zwei Positionen ermittelt werden.

Eine Vielzahl von Modulation können eine genaue Bestimmung der Grundschwingung im Zeitbereich erschweren, insbesondere eine Ungenauigkeit in der Identifizierung von Nulldurchgängen und Maximalwerten im Rahmen einer graphischen Auswertung bedingen. (Zur Auswertung im Zeitbereich siehe auch die vorausgehende Beschreibung der Fig. 4.) Im Zeitbereich wird oft nur eine Schwingung ermittelt, da sich überlappende Schwingungen nicht immer direkt erkennbar sind.

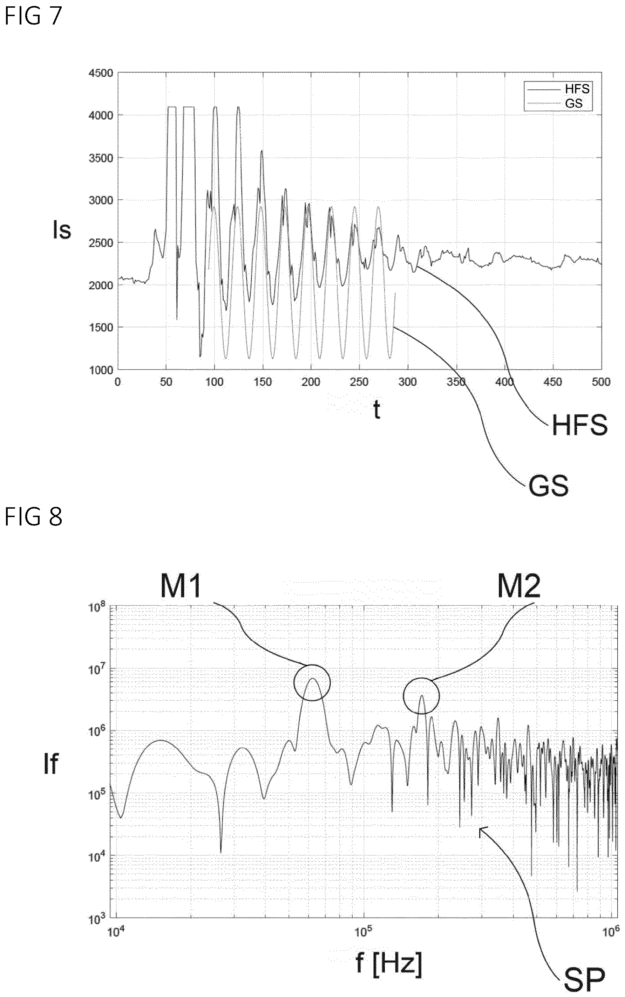

Fig. 7 zeigt das HF-Signal HFS der Fig. 6 mit einer überlagerten Grundschwingung GS der Schwingung, wobei die Frequenz der Grundschwingung GS z. B. aus einer Auswertung im Frequenzbereich gewonnen wurde. Die Korrelation zwischen Grundwelle GS und HF-Signal HFS ist ein Parameter für die Qualitätsangabe der identifizierten Grundwelle GS.

Fig. 8 verdeutlicht eine Auswertung der Grundschwingung des HF-Signal HFS der Fig. 5 über ein Frequenzspektrum SP, d. h. im Frequenzbereich (Frequenzstärke If aufgetragen über Frequenz f in einem für den Prüfling relevanten Frequenzbereich). Allgemein kann das HF-Signal HFS (und/oder unter Umständen das Vorortungssignal) manuell oder automatisch entsprechend der Länge der Kabelstrecke und/oder der Ausbreitungsgeschwindigkeit aufbereitet werden (Signalverarbeitung, Fensterung), bevor es in den Frequenzbereich transformiert wird. Beispielhaft wurden im Frequenzspektrum SP zwei Frequenzmaxima M1, M2 für zwei dominante Schwingungen gekennzeichnet. Im Rahmen einer Korrelationsüberprüfung hat sich die Frequenz des Maximums M1 als unzutreffend herausgestellt. Die Frequenz des Maximums M2 wurde in Fig. 6 dem HF-Signal HFS überlagert und entspricht der Frequenz der Grundschwingung, die im Rahmen der Fehlervorortung auf die Entfernung des Fehlers rückschließen lässt.

Es wird angemerkt, dass das Ergebnis der Fehlervorortung nicht zwangsläufig einen Fehler in der Isolation darstellen muss. Vielmehr ergibt sich eine Wahrscheinlichkeit. Bildet sich eine Clusterbildung von bestimmten Fehlerdistanzen um einen Ort während der Messung, d.h. im Rahmen der kontinuierlichen Überwachung und Auswertung, kann dies als Indiz für einen realen Fehler der Isolation oder eine baldige Ausbildung eines Fehlers angesehen werden.

Zeigt die Auswertung auf einen Fehler der Isolation bei einer realen Fehlerdistanz kann in Reaktion eine erneute Messung zur Bestätigung im Sinne einer eindeutigen Identifikation fortgesetzt werden. Alternativ kann das Ergebnis der Auswertung die Steuerung veranlassen, zum Schutz des Kabels die VLF-Prüfung vorzeitig abzubrechen, sodass die üblicherweise im Bereich der 2 bis 3-fachen Nutzspannung U0 liegende Maximalspannung der Tangens-Delta-messung nicht erreicht wird. Auf diese Weise kann der Prüfling geschont und beispielsweise eine Fehlstellenverfestigung oder auch ein Durchschlag vermieden werden.

Die hierin beschriebenen Verfahren zur Fehlerortung betreffen insbesondere Kabeldefekte mit hohem Widerstand oder vorübergehend auftretende Defekte. In den Verfahren werden Messungen an einem Stromsignal durchgeführt, das durch einen angeschlossenen Prüfling (Device Under Test, DUT; Energiekabel, Koaxialkabel, ...) fließt. Kommt es am Prüfling z. B. zu einem Durchschlag (Arc, Breakdown), löst dieser eine transiente Welle (Schwingung) aus, deren Frequenz / Periodendauer proportional zur Entfernung des Durchschlags ist. Da der Prüfling als Energiekabel meist am Schirm direkt an Schutzerde angeschlossen ist, wird vorgeschlagen, den Strom an geeigneter Stelle im VLF-HV-Generator - am sogenannten IE-Sammelpunkt (internes Erdpotential) - zu erfassen.

Die in der vorliegenden Beschreibung verwendeten Merkmale der Verfahren und Geräte, die mit "Einheit", "Vorrichtung" oder ähnlichem bezeichnet wurden, können z. B. als diskrete physikalische Einheiten, als konzeptionelle Funktionseinheiten, z. B. als Softwarecode (im Rahmen eines Auswerteprogramms), der in einer Speichereinheit (Speicher) gespeichert ist, als Routinen von einem Mikroprozessor und/oder innerhalb einer hybriden Hardware/Firmware-Struktur im Rahmen der Kenntnis des Fachmanns umgesetzt werden. Darüber hinaus können zwei oder mehr "Einheiten" etc. zusammen in einer einzigen physikalischen Schaltungsstruktur (z. B. eine integrierte Einheit oder Struktur) integriert werden. Beispielsweise kann ein Prozessor durch Programmiercode (gespeicherte Anweisungen) gesteuert werden, wobei der Programmiercode in der Lage ist, die jeweiligen Funktionen auszuführen, wenn er von einem Prozessor, wie beispielsweise einem Mikroprozessor, ausgeführt wird.

Die insbesondere in den Ansprüchen genannten Merkmale können somit als Software, Hardware und/oder eine Kombination aus Hard- und Software ausgebildet werden. Spezifische Details der einzelnen Einheiten sind in der Beschreibung (und insbesondere in den exemplarischen Abschnitten) beschrieben. Diese bietet einem Fachmann ausreichend Information, um die entsprechenden Strukturen in Hardwareschaltungen oder Software-Code umzusetzen. Als Beispiel kann die hierin offenbarte "Auswerteeinheit" in der Struktur einer zentralen Verarbeitungseinheit (CPU) verkörpert sein, die mit Anweisungen zum Ausführen der Operationen zum Ableiten von Grundschwingungsinformationen konfiguriert ist. Die CPU kann einen oder mehrere Mikroprozessoren in Verbindung mit einem oder mehreren Speicherelementen umfassen. Ein Speicherelement kann eine oder mehrere mikroprozessorlesbare Anweisungen (Programme) speichern, die bei Ausführung durch den Mikroprozessor beispielsweise die Fourier- oder Wavelet-Transformation durchführen. Darüber hinaus können die Mess- und Auswerteeinheit 9 und die Steuerung verschiedene Einheiten umfassen, die miteinander interagieren, um die gewünschten Aktionen wie das Empfangen von, Zugreifen auf und/oder das Senden von Datensätzen, das Identifizieren von Maxima usw. durchzuführen.

Es wird explizit festgehalten, dass alle Bereichsangaben oder Angaben von Gruppen von Einheiten jeden möglichen Zwischenwert oder Untergruppe von Einheiten zum Zweck der ursprünglichen Offenbarung ebenso wie zum Zweck des Einschränkens der beanspruchten Erfindung offenbaren, insbesondere auch als Grenze einer Bereichsangabe.

## Patentansprüche

1. Prüfgerät (1) zur Prüfung eines Hoch- oder Mittelspannungskabels (3) mittels eines Very-Low-Frequency (VLF)-Prüfverfahrens umfassend:
eine Schaltungsanordnung (5) mit
- einer Prüfspannungserzeugungseinheit (7), die einen niederspannungsseitigen Erdungseingang (7A) und einen hochspannungsseitigen Ausgang (7B) umfasst und zur Bereitstellung einer variablen Prüfspannung am hochspannungsseitigen Ausgang (7B) ausgebildet ist,
- einem Stromanschluss (15) zum Anschließen der Prüfspannungserzeugungseinheit (7) an eine Versorgungsspannungsquelle,
- einem Prüflinganschluss (33) zum Verbinden des hochspannungsseitigen Ausgangs (7B) mit einem Leiter (3A) des Hoch- oder Mittelspannungskabels (3), insbesondere über ein Messanschlusskabel (17),
- einem Schutzerdeanschluss (35) zum Verbinden mit Schutzerde (19),
- einem Verbindungsleiter (39), der den niederspannungsseitigen Erdungseingang (7A) mit dem Schutzerdeanschluss (35) elektrisch verbindet, sodass der Verbindungsleiter (39) einen Stromsammelpunkt darstellt, der bei der Prüfung des Hoch- oder Mittelspannungskabels (3) von einem Messstrom durchflossen wird, der sich zwischen dem niederspannungsseitigen Erdungseingang (7A) und einem ebenfalls an Schutzerde (19) angeschlossenen Schirm (3B) des Hoch- oder Mittelspannungskabels (3) ausbildet,
- einem niederfrequenten Signalabgriff (41) am Stromsammelpunkt, an dem basierend auf dem Messstrom ein niederfrequentes Diagnosesignal erzeugt wird, und
- einem hochfrequenten Signalabgriff (43) am Stromsammelpunkt, an dem basierend auf dem Messstrom ein hochfrequentes Vorortungssignal für eine Messung einer transienten hochfrequenten Schwingung erzeugt wird, und
eine Auswerteelektronik (9), die
- mit dem niederfrequenten Signalabgriff (41) zur Aufnahme des niederfrequenten Diagnosesignals verbunden und für eine VLF-Phasendrehungsmessung ausgebildet ist und
- mit dem hochfrequenten Signalabgriff (43) zur Aufnahme des hochfrequenten Vorortungssignals verbunden und für eine Fehlerabstandsauswertung ausgebildet ist.

2. Prüfgerät (1) nach Anspruch 1, wobei die Schaltungsanordnung (5) dazu eingerichtet ist, mit der variablen Prüfspannung gleichzeitig das niederfrequente Diagnosesignal für eine Isolationsprüfung des Hoch- oder Mittelspannungskabels über die VLF-Phasendrehungsmessung und das hochfrequente Vorortungssignal für eine Fehlervorortung über die Messung transienter hochfrequenter Schwingungen zu erzeugen, und/oder
wobei der niederspannungsseitigen Erdungseingang (7A) nur über den Verbindungsleiter (39) mit Schutzerde (19) verbindbar ist.

3. Prüfgerät (1) nach Anspruch 1 oder 2, wobei der hochfrequente Signalabgriff (43) eine elektrische und/oder magnetische Kopplung mit dem Verbindungsleiter (39) umfasst und die Kopplung zur Erfassung des Vorortungssignals mit Frequenzen im Bereich von 20 kHz bis 2 MHz mit einer Abtastrate mit Frequenzen im Bereich von 1 MHz bis mehreren 100 MHz ausgebildet ist.

4. Prüfgerät (1) nach Anspruch 3, wobei die Kopplung als
- eine induktive Kopplung, insbesondere über eine Spule (43A) wie eine Rogowski-Spule oder eine Spule mit oder ohne induktiven Kern
ausgebildet ist, und/oder
wobei der hochfrequente Signalabgriff (43) dazu eingerichtet ist, kontinuierlich eine hochfrequente Stromschwingung im Verbindungsleiter (39) zu erfassen, und
die hochfrequente Stromschwingung insbesondere bei einem Durchschlag der Isolation (3C) im Hoch- oder Mittelspannungskabel (3) oder eine mit einem bevorstehenden Durchschlag in Zusammenhang stehende hochfrequente Stromschwingung erfassbar ist.

5. Prüfgerät (1) nach einem der vorhergehenden Ansprüche, wobei die Auswerteelektronik (9) dazu eingerichtet ist,
- aus dem Vorortungssignal eine der hochfrequenten Stromschwingung zugeordnete Abstandsgröße abzuleiten,
- die Abstandsgröße hinsichtlich einer Plausibilität unter Berücksichtigung eines bekannten Parameters des Hoch- oder Mittelspannungskabels (3), insbesondere einer Länge des Hoch- oder Mittelspannungskabels (3), zu bewerten, und
- eine dem Hoch- oder Mittelspannungskabel (3) zugeordnete Fehlerabstandsgröße (D) auszugeben.

6. Prüfgerät (1) nach einem der vorhergehenden Ansprüche, wobei die Prüfspannungserzeugungseinheit (7) die Prüfspannung für eine Tangens-Delta-Messung erzeugt und
der niederfrequente Signalabgriff (41)
- dazu eingerichtet ist, einen Momentanwert einer Stromstärke im Verbindungsleiter (39) zu erfassen, und/oder
- eine Impedanz (41A) im Verbindungsleiter (39), insbesondere eine Parallelschaltung aus Widerstand und Kondensator, umfasst.

7. Prüfgerät (1) nach Anspruch 6, wobei die Auswerteelektronik (9) dazu eingerichtet ist, aus dem Diagnosesignal einen dem Hoch- oder Mittelspannungskabel (3) zugeordneten Verlustfaktor zu bestimmen, und insbesondere zur Erfassung niedriger Frequenzen des Diagnosesignals im Bereich von 0.01 Hz bis 1 Hz mit einer Abtastrate mit Frequenzen im Bereich von 500 Hz bis 10 kHz ausgelegt ist.

8. Prüfgerät (1) nach einem der vorhergehenden Ansprüche, wobei die Auswerteelektronik
- mindestens eine analoge und/oder digitale Signalverarbeitungseinheit und/oder
- einen Prozessor und/oder einen Buffer-Speicher (111)
umfasst.

9. Prüfgerät (1) nach einem der vorhergehenden Ansprüche, wobei das Prüfgerät (1) ferner eine Steuerungseinheit (23) mit einem Speicher und einer Anzeige (25A) umfasst, wobei die Steuerungseinheit (23) mit der Auswerteelektronik (9) verbunden ist und dazu eingerichtet ist, eine Fehlerabstandsgröße im Speicher abzulegen, auf der Anzeige (25A) auszugeben und/oder eine Fehlerabstandsgröße als Steuerungsparameter zur Steuerung des Prüfgeräts (1), insbesondere für einen Abbruch einer VLF-Prüfung, zu verwenden.

10. Prüfgerät (1) nach einem der vorhergehenden Ansprüche, wobei das Prüfgerät (1) ferner ein Gehäuse (21) umfasst, in dem die Schaltungsanordnung (5) und die Auswerteelektronik und optional eine Steuerungseinheit (23) angeordnet sind.

11. Verfahren zur Prüfung eines Hoch- oder Mittelspannungskabels (3), insbesondere unter Verwendung eines Prüfgeräts (1) nach einem der vorhergehenden Ansprüche, mit den Schritten:
- Bewirken eines Messtroms mit einer Prüfspannungserzeugungseinheit (7) bei angeschlossenem Hoch- oder Mittelspannungskabel (3) in einem Verbindungsleiter (39), der einen niederspannungsseitigen Erdungseingang (7A) der Prüfspannungserzeugungseinheit (7) über einen Schutzerdeanschluss (35) mit Schutzerde (19) verbindet, wobei der Verbindungsleiter (39) einen Stromsammelpunkt darstellt, der vom Messstrom durchflossen wird, und der Messstrom sich zwischen dem niederspannungsseitigen Erdungseingang (7A) und eines ebenfalls an Schutzerde (19) angeschlossenen Schirms (3B) des Hoch- oder Mittelspannungskabels (3) ausbildet,
- Erzeugen eines dem Messstrom zugeordneten niederfrequenten Diagnosesignals für eine VLF-Phasendrehungsmessung mit einem niederfrequenten Signalabgriff (41) am Stromsammelpunkt (Schritt 105A),
- Erzeugen eines dem Messstrom zugeordneten hochfrequenten Vorortungssignals für eine Fehlerabstandsauswertung mit einem hochfrequenten Signalabgriff (43) am Stromsammelpunkt (107B), wobei das hochfrequente Vorortungssignal kontinuierlich während der VLF-Phasendrehungsmessung erzeugt wird, und
- Auswerten des hochfrequenten Vorortungssignals in einer Auswerteelektronik (9) hinsichtlich eines Fehlerabstands (D) (Schritt 107C).

12. Verfahren nach einem der Ansprüche 11, wobei die Auswertung hinsichtlich eines Fehlerabstands zum Erkennen von Wanderwellen, die von einem Fehler im Hoch- oder Mittelspannungskabel (9) ausgelöst werden, von einem Prozessor durchgeführt wird und die folgenden Schritte umfasst:
- kontinuierliches Abtasten und Fenstern des Vorortungssignals, insbesondere mit einem Analog-Digital-Wandler, wobei ein fortlaufender Messdatensatz erzeugt wird (Schritt 109),
- Zwischenspeichern des Messdatensatzes in einem zyklischen Speicher (111),
- Identifizieren einer Mehrzahl von dominanten Schwingungen im Messdatensatz (Schritt 113),
- Korrelieren der identifizierten dominanten Schwingungen mit dem zwischengespeicherten Messdatensatz (Schritt 115) und
- Prüfen der Plausibilitäten mindestens einer ausgewählten identifizierten dominanten Schwingung für das Hoch- oder Mittelspannungskabel (Schritt 115).

13. Verfahren nach Anspruch 12, wobei der Prozessor zum Identifizieren der Mehrzahl von dominanten Schwingungen dazu ausgebildet ist,
- Nulldurchgänge und/oder Spitzenwerte im Messdatensatz zu erkennen und/oder
- den Messdatensatz von einer Anzeige (25A) darstellen zu lassen und von einem Bediener festgelegte Nulldurchgänge und/oder Spitzenwerte einzulesen (Schritt 121), und
aus den Nulldurchgängen und/oder Spitzenwerten eine dominante Schwingung für das Korrelieren mit dem zwischengespeicherten Messdatensatz abzuleiten (Schritt 123); und/oder
wobei der Prozessor zum Identifizieren der Mehrzahl von dominanten Schwingungen dazu ausgebildet ist,
eine diskrete Fouriertransformation auf den Messdatensatz anzuwenden und einen transformierten Messdatensatz im Frequenzbereich zu erzeugen (Schritt 131), mindestens eine dominante Schwingungsfrequenz zu erkennen (Schritt 133), die mindestens eine dominante Schwingungsfrequenz in den Zeitbereich zurück zu transformieren (Schritt 135) und als mindestens eine dominante Schwingung für das Korrelieren mit dem zwischengespeicherten Messdatensatz abzuleiten; und/oder
wobei der Prozessor zum Identifizieren der Mehrzahl von dominanten Schwingungen dazu ausgebildet ist,
eine kontinuierliche Wavelet-Transformation auf den Messdatensatz anzuwenden (Schritt 141), mindestens eine dominante Ausprägung im Spektrum zu erkennen (Schritt 143), die mindestens eine dominante Ausprägung in den Zeitbereich überzuführen (Schritt 145) und als mindestens eine dominante Schwingung für das Korrelieren mit dem zwischengespeicherten Messdatensatz abzuleiten.

14. Verfahren nach einem der Ansprüche 11 bis 13, wobei das hochfrequente Vorortungssignal derart hinsichtlich eines Fehlerabstands ausgewertet wird, dass für eine Grundschwingung, deren Plausibilität über einem Schwellwert liegt, eine Fehlerabstandsgröße berechnet wird (Schritt 119A), und/oder
wobei der Grundschwingung zugeordnete Parameter wie Schwingungsfrequenz, Periodizität und Qualitätsangabe und/oder die Fehlerabstandsgröße
- in einem Speicher abgelegt wird,
- in einem Messprotokoll abgespeichert wird (109B),
- auf einer Anzeige ausgegeben wird (109C) und/oder
- einer Steuerung des Prüfgeräts als Steuerungsparameter, insbesondere für ein einen Abbruch einer VLF-Prüfung, zugeführt wird.

## Claims

1. A testing device (1) for testing a high or medium-voltage cable (3) using a very low frequency (VLF) testing method, comprising:
a circuit arrangement (5) with
- a test voltage generator (7) that comprises a low-voltage-side earthing input (7A) and a high-voltage-side output (7B) and is configured to provide a variable test voltage at the high-voltage-side output (7B),
- a power connection (15) for connecting the test voltage generator (7) to a supply voltage source,
- a test specimen connection (33) for connecting the high-voltage-side output (7B) to a conductor (3A) of the high or medium-voltage cable (3), in particular via a measuring connection cable (17),
- a protective earth connection (35) for connecting to protective earth (19),
- a connecting conductor (39) that electrically connects the low-voltage-side earthing input (7A) to the protective earth connection (35), so that the connecting conductor (39) represents a current collection point through which a measuring current flows during the test of the high- or medium-voltage cable (3), which current is formed between the low-voltage-side earthing input (7A) and a shield (3B) of the high or medium-voltage cable (3), which shield is also connected to protective earth (19),
- a low-frequency signal pick-up (41) at the current collection point, at which a low-frequency diagnostic signal is generated based on the measuring current, and
- a high-frequency signal pick-up (43) at the current collection point, at which a high-frequency pre-location signal for a measurement of a transient high-frequency oscillation is generated based on the measuring current, and
an evaluation electronics (9) that
- is connected to the low-frequency signal pick-up (41) for receiving the low-frequency diagnostic signal and is configured for a VLF phase rotation measurement, and
- is connected to the high-frequency signal pick-up (43) for recording the high-frequency pre-location signal and is configured for defect distance evaluation.

2. The testing device (1) of claim 1, wherein the circuit arrangement (5) is configured to, using the variable test voltage, simultaneously generate the low-frequency diagnostic signal for an insulation test of the high or medium-voltage cable via the VLF phase rotation measurement and the high-frequency pre-location signal for defect pre-location via the measurement of transient high-frequency oscillations, and/or wherein the low-voltage-side earthing input (7A) is only connectable to protective earth (19) via the connecting conductor (39).

3. The testing device (1) of claim 1 or 2, wherein the high-frequency signal pick-up (43) comprises an electrical and/or magnetic coupling with the connecting conductor (39) and the coupling is configured to detect the pre-location signal with frequencies in the range from 20 kHz to 2 MHz with a sampling rate with frequencies in the range from 1 MHz to several 100 MHz.

4. The testing device (1) of claim 3, wherein the coupling is configured as
- an inductive coupling, in particular via a coil (43A) such as a Rogowski coil or a coil with or without an inductive core, and/or
wherein the high-frequency signal pick-up (43) is arranged to continuously detect a high-frequency current oscillation in the connecting conductor (39), and
the high-frequency current oscillation is detectable in particular during a breakdown of an insulation (3C) in the high or medium-voltage cable (3) or a high-frequency current oscillation is detectable, which is associated with an impending breakdown.

5. The testing device (1) according to any one of the preceding claims, wherein the evaluation electronics (9) is configured
- to derive, from the pre-location signal, a distance value associated with the high-frequency current oscillation,
- to evaluate the distance value with respect to a plausibility, taking into account a known parameter of the high or medium-voltage cable (3), in particular a length of the high or medium-voltage cable (3), and
- to output a defect distance value (D) associated with the high or medium-voltage cable (3).

6. The testing device (1) according to any one of the preceding claims, wherein the test voltage generator (7) generates the test voltage for a tangent-delta-measurement, and the low-frequency signal pick-up (41)
- is configured to detect an instantaneous value of a current in the connecting conductor (39), and/or
- comprises an impedance (41A) in the connecting conductor (39), in particular a parallel circuit of resistor and capacitor.

7. The testing device (1) of claim 6, wherein the evaluation electronics (9) is configured to determine, from the diagnostic signal, a loss factor associated with the high or medium-voltage cable (3), and in particular is configured to detect low frequencies of the diagnostic signal in the range from 0.01 Hz to 1 Hz with a sampling rate with frequencies in the range from 500 Hz to 10 kHz.

8. The testing device (1) according to any one of the preceding claims, wherein the evaluation electronics comprises
- at least one analog and/or digital signal processing unit and/or
- a processor and/or a buffer memory (111).

9. The testing device (1) according to one of the preceding claims, wherein the testing device (1) further comprises a control (23) with a memory and a display (25A), wherein the control (23) is connected to the evaluation electronics (9) and is set up to store a defect distance value in the memory, to output it on the display (25A) and/or to use a defect distance value as a control parameter for controlling the testing device (1), in particular for aborting a VLF-test.

10. The testing device (1) according to any one of the preceding claims, wherein the testing device (1) further comprises a housing (21) in which the circuit arrangement (5) and the evaluation electronics and optionally a control (23) are arranged.

11. A method for testing a high or medium-voltage cable (3), in particular using a testing device (1) according to any one of the preceding claims, comprising the steps of:
- with a test voltage generator (7) having a high or medium-voltage cable (3) connected, causing a measuring current in a connecting conductor (39), which connects a low-voltage-side earthing input (7A) of the test voltage generator (7) to protective earth (19) via a protective earth connection (35), wherein the connecting conductor (39) represents a current collection point, through which the measuring current flows, and the measuring current is formed between the low-voltage-side earthing input (7A) and a shield (3B) of the high or medium-voltage cable (3), which is also connected to protective earth (19),
- for a VLF phase rotation measurement, generating a low-frequency diagnostic signal associated with the measuring current with a low-frequency signal pick-up (41) at the current collection point (Step 105A),
- for a defect distance evaluation, generating a high-frequency pre-location signal associated with the measuring current with a high-frequency signal pick-up (43) at the current collection point (107B), the high-frequency pre-location signal being generated continuously during the VLF phase rotation measurement, and
- evaluating the high-frequency pre-location signal in an evaluation electronics (9) with respect to a defect distance (D) (Step 107C).

12. The method of claim 11, wherein the evaluation with respect to a defect distance for detecting traveling waves, which are triggered by a defect in the high or medium-voltage cable (9), is performed by a processor and comprises the following steps:
- continuous sampling and windowing of the pre-location signal, in particular with an analog-to-digital converter, wherein a continuous measurement data set is generated (Step 109),
- storing temporarily the measurement data set in a cyclical memory (111),
- identifying a plurality of dominant oscillations in the measurement data set (Step 113),
- correlating the identified dominant oscillations with the temporarily stored measurement data set (Step 115), and
- checking a plausibility of at least one selected identified dominant oscillation for the high or medium-voltage cable (Step 115).

13. The method of claim 12, wherein the processor for identifying the plurality of dominant oscillations is configured to
- recognize zero crossings and/or peak values in the measurement data set, and/or
- to have the measurement data set displayed by a display (25A) and to read zero crossings and/or peak values determined by an operator (Step 121), and
from the zero crossings and/or peak values, derive a dominant oscillation for correlation with the temporarily stored measurement data set (Step 123); and/or
wherein the processor for identifying the plurality of dominant oscillations is configured to
apply a discrete Fourier transform to the measurement data set and generate a transformed measurement data set in the frequency domain (Step 131), recognize at least one dominant oscillation frequency (Step 133), transform the at least one dominant oscillation frequency back into the time domain (Step 135), and derive it as at least one dominant oscillation for correlating with the temporarily stored measurement data set; and/or
wherein the processor for identifying the plurality of dominant oscillations is configured to
apply a continuous wavelet transform to the measurement data set (Step 141), recognize at least one dominant characteristic in the spectrum (Step 143), transfer the at least one dominant characteristic into the time domain (Step 145) and derive it as at least one dominant oscillation for correlation with the temporarily stored measurement data set.

14. The method of any one of claims 11 to 13, wherein the high-frequency pre-location signal is evaluated with respect to a defect distance such that a defect distance value is calculated for a fundamental oscillation having a plausibility above a threshold value (Step 119A), and/or
wherein a parameter associated with the fundamental oscillation, such as oscillation frequency, periodicity and quality specification, and/or the defect distance value is at least one of
- stored in a memory,
- saved in a measurement log (109B),
- output on a display (109C) and/or
- fed to a control of the testing device as a control parameter, in particular for aborting a VLF-test.

## Revendications

1. Dispositif de test (1) pour tester un câble à haute ou moyenne tension (3) au moyen d'une méthode de test à très basse fréquence (VLF), comprenant un circuit (5) avec
- une unité de génération de tension de test (7), qui comprend une entrée de terre à basse tension (7A) et une sortie à haute tension (7B) et est conçue pour fournir une tension de test variable à la sortie à haute tension (7B),
- une connexion d'alimentation (15) pour connecter l'unité de génération de tension de test (7) à une source de tension d'alimentation,
- une connexion d'objet de test (33) pour connecter la sortie à haute tension (7B) à un conducteur (3A) du câble à haute ou moyenne tension (3), notamment via un câble de connexion de mesure (17),
- une borne de terre de protection (35) pour la connexion à la terre de protection (19),
- un conducteur de connexion (39) qui connecte électriquement l'entrée de terre à basse tension (7A) à la borne de terre de protection (35), de sorte que le conducteur de connexion (39) représente un point de collecte de courant à travers lequel circule pendant le test du câble à haute ou moyenne tension (3) un courant de mesure, qui s'établit entre l'entrée de terre à basse tension (7A) et un blindage (3B) du câble à haute ou moyenne tension (3) qui est également connecté à la terre de protection (19),
- une prise de signal à basse fréquence (41) au point de collecte de courant, au niveau de laquelle un signal de diagnostic à basse fréquence est généré sur la base du courant de mesure, et
- une prise de signal à haute fréquence (43) au point de collecte de courant, au niveau de laquelle un signal de pré-localisation à haute fréquence pour mesurer une oscillation à haute fréquence transitoire est généré sur la base du courant de mesure, et
une électronique d'évaluation (9) qui
- est connectée à la prise de signal à basse fréquence (41) pour recevoir le signal de diagnostic à basse fréquence et est conçue pour une mesure de rotation de phase VLF et
- est connectée à la prise de signal à haute fréquence (43) pour recevoir le signal de pré-localisation à haute fréquence et est conçue pour l'évaluation de la distance d'erreur.

2. Dispositif de test (1) selon la revendication 1, dans lequel le circuit (5) est conçu pour générer simultanément le signal de diagnostic à basse fréquence pour un contrôle d'isolation du câble à haute ou moyenne tension via la mesure de rotation de phase VLF et le signal de pré-localisation à haute fréquence pour la pré-localisation d'erreur via la mesure d'oscillations transitoires à haute fréquence, et/ou dans lequel l'entrée de terre à basse tension (7A) ne peut être connectée à la terre de protection (19) que via le conducteur de connexion (39).

3. Dispositif de test (1) selon la revendication 1 ou 2, dans lequel la prise de signal à haute fréquence (43) comprend un couplage électrique et/ou magnétique avec le conducteur de connexion (39) et le couplage est conçu pour détecter le signal de pré-localisation avec des fréquences dans la plage de 20 kHz à 2 MHz avec une fréquence d'échantillonnage avec des fréquences dans la plage de 1 MHz à plusieurs centaines de 100 MHz.

4. Dispositif de test (1) selon la revendication 3, dans lequel le couplage est
- conçu comme un couplage inductif, notamment via une bobine (43A) telle qu'une bobine de Rogowski ou une bobine avec ou sans noyau inductif, et/ou
dans lequel la prise de signal à haute fréquence (43) est conçue pour détecter en continu une oscillation de courant à haute fréquence dans le conducteur de connexion (39) et
pour détecter l'oscillation de courant à haute fréquence, notamment en cas d'une rupture de l'isolation (3C) dans le câble à haute tension ou moyenne tension (3) ou d'une rupture imminente dans une oscillation de courant à haute fréquence associée.

5. Dispositif de test (1) selon une des revendications précédentes, dans lequel l'électronique d'évaluation (9) est conçue pour
- dériver une valeur de distance associée à l'oscillation de courant à haute fréquence à partir du signal de pré-localisation,
- évaluer la taille de distance en ce qui concerne une plausibilité en tenant compte d'un paramètre connu du câble à haute ou moyenne tension (3), notamment une longueur du câble à haute ou moyenne tension (3), et
- délivrer une valeur de distance d'erreur (D) attribuée au câble à haute ou moyenne tension (3).

6. Dispositif de test (1) selon une quelconque des revendications précédentes, dans lequel l'unité de génération de tension de test (7) génère la tension de test pour une mesure tangente-delta et la prise de signal à basse fréquence (41)
- est conçue pour détecter une valeur instantanée d'une intensité de courant dans le conducteur de connexion (39), et/ou
- comprend une impédance (41A) dans le conducteur de liaison (39), notamment un circuit parallèle de résistance et de condensateur.

7. Dispositif de test (1) selon la revendication 6, dans lequel l'électronique d'évaluation (9) est configurée pour déterminer un facteur de perte associé au câble à haute ou moyenne tension (3) à partir du signal de diagnostic et notamment pour détecter les basses fréquences du signal de diagnostic dans la plage de 0,01 Hz à 1 Hz avec une fréquence d'échantillonnage de fréquences dans la plage de 500 Hz à 10 kHz.

8. Dispositif de test (1) selon une des revendications précédentes, dans lequel l'électronique d'évaluation comprend
- au moins une unité de traitement de signal analogique et/ou numérique et/ou
- un processeur et/ou une mémoire tampon (111).

9. Dispositif de test (1) selon une quelconque des revendications précédentes, dans lequel le dispositif de test (1) comprend en outre une unité de commande (23) avec une mémoire et un écran (25A), dans lequel l'unité de commande (23) est connectée à l'électronique d'évaluation (9) et est conçue pour stocker une valeur de distance d'erreur dans la mémoire, l'afficher sur l'écran (25A) et/ou utiliser une valeur de distance d'erreur comme paramètre de commande pour commander le dispositif de test (1), notamment pour interrompre un test VLF.

10. Dispositif de test (1) selon une des revendications précédentes, dans lequel le dispositif de test (1) comprend en outre un boîtier (21), dans lequel sont disposés le circuit (5) et l'électronique d'évaluation et optionnellement une unité de commande (23).

11. Procédé de test d'un câble à haute ou moyenne tension (3), notamment en utilisant un dispositif de test (1) selon une des revendications précédentes, comportant les étapes consistant à :
- générer un courant de mesure au moyen d'une unité de génération de tension de test (7) connectée à un câble à haute ou moyenne tension (3) dans un conducteur de connexion (39), qui connecte une entrée de terre à basse tension (7A) de l'unité de génération de tension de test (7) à la terre de protection (19) via une borne de terre de protection (35), dans lequel le conducteur de connexion (39) constitue un point de collecte de courant, qui est traversé par le courant de mesure et le courant de mesure s'établit entre l'entrée de terre à basse tension (7A) et un blindage (3B) du câble à haute ou moyenne tension (3), également connecté à la terre de protection (19),
- générer un signal de diagnostic à basse fréquence associé au courant de mesure pour une mesure de rotation de phase VLF avec une prise de signal à basse fréquence (41) au point de collecte de courant (étape 105A),
- générer un signal de pré-localisation à haute fréquence associé au courant de mesure pour une évaluation de distance d'erreur avec une prise de signal à haute fréquence (43) au point de collecte de courant (107B), dans lequel le signal de pré-localisation à haute fréquence est généré en continu pendant la mesure de rotation de phase VLF, et
- évaluer le signal de pré-localisation à haute fréquence dans une électronique d'évaluation (9) en fonction d'une distance d'erreur (D) (étape 107C).

12. Procédé selon une des revendications 11, dans lequel l'évaluation de la distance d'erreur pour la détection d'ondes progressives, qui sont déclenchées par un défaut dans le câble à haute ou moyenne tension (9), est effectuée par un processeur et comprend les étapes suivantes :
- échantillonnage et fenêtrage continus du signal de pré-localisation, notamment avec un convertisseur analogique-numérique, dans lequel un ensemble de données de mesure continu est généré (étape 109),
- mise en mémoire tampon de l'ensemble de données de mesure dans une mémoire cyclique (111),
- identification d'une majorité d'oscillations dominantes dans l'ensemble de données de mesure (étape 113),
- corrélation des oscillations dominantes identifiées avec l'ensemble de données de mesure mises en mémoire tampon (étape 115) et
- vérification de la plausibilité d'au moins une oscillation dominante identifiée sélectionnée pour le câble à haute ou moyenne tension (étape 115).

13. Procédé selon la revendication 12, dans lequel le processeur pour identifier la pluralité d'oscillations dominantes est configuré pour
- détecter les passages à zéro et/ou les valeurs de crête dans l'ensemble de données de mesure et/ou
- afficher l'ensemble des données de mesure sur un écran (25A) et lire les passages à zéro et/ou les valeurs de crête définies par un opérateur (étape 121), et
dériver une oscillation dominante à partir des passages à zéro et/ou des valeurs de crête pour la corrélation avec l'ensemble de données de mesure mises en mémoire tampon (étape 123) ; et/ou
dans lequel le processeur est configuré pour identifier la pluralité d'oscillations dominantes, appliquer une transformation de Fourier discrète à l'ensemble de données de mesure et générer un ensemble de données de mesure transformées dans le domaine fréquentiel (étape 131), détecter au moins une fréquence d'oscillation dominante (étape 133), qui a au moins une fréquence d'oscillation dominante dans le domaine temporel (étape 135) et dériver en tant qu'au moins une oscillation dominante pour la corrélation avec l'ensemble de données de mesure mises en mémoire tampon; et/ou
dans lequel le processeur pour identifier la pluralité d'oscillations dominantes est conçu pour appliquer une transformation en ondelettes continue à l'ensemble de données de mesure (étape 141), détecter au moins une caractéristique dominante dans le spectre (étape 143), transférer au moins une caractéristique dominante dans le domaine temporel (étape 145) et dériver en tant qu'au moins une oscillation dominante pour la corrélation avec l'ensemble de données de mesure mises en mémoire tampon.

14. Procédé selon une des revendications 11 à 13, dans lequel le signal de pré-localisation à haute fréquence est évalué par rapportàune distance d'erreur de telle sorte que pour une oscillation fondamentale, dont la plausibilité est supérieure à une valeur seuil, une valeur de distance d'erreur est calculée (étape 119A) et/ou
dans lequel les paramètres attribués à l'oscillation fondamentale tels que la fréquence d'oscillation, la périodicité et les informations de qualité et/ou la valeur de distance d'erreur sont
- stockés dans une mémoire,
- stockés dans un protocole de mesure (109B),
- affiché sur un écran (109C) et/ou
- transmis à une commande du dispositif de test en tant que paramètre de commande, notamment pour interrompre un test VLF.
